# EUROPEAN PATENT APPLICATION

(11) **EP 4 654 267 A1**
(43) Date of publication of application: **26.11.2025**
(21) Application number: 23917839.5
(22) Date of filing: 10.08.2023
(51) Int. Cl.: H01L 33/00, H01L 33/20, H01L 33/06, H01L 33/38, H01L 33/44, H01L 33/30, H01L 25/075, H01L 27/12, H01L 33/62

(54) **METHOD FOR MANUFACTURING LIGHT-EMITTING DEVICE, LIGHT-EMITTING DEVICE, AND DISPLAY DEVICE COMPRISING LIGHT-EMITTING DEVICE**

(30) Priority: 17.01.2023 KR 20230006916
(71) Applicant: Samsung Display Co., Ltd., Yongin-si, Gyeonggi-do 17113 (KR)
(72) Inventor: LEE, Yo Han, Yongin-si, Gyeonggi-do 17113 (KR)
(74) Representative: Marks & Clerk LLP
(86) International application number: PCT/KR2023/011823
(87) International publication number: WO 2024/154881

(57) **Abstract**

A method of manufacturing a light emitting element includes patterning a first semiconductor layer on a substrate; patterning a first insulating layer on a side surface of the first semiconductor layer; and forming an active layer and a second semiconductor layer on the first semiconductor layer.

## Description

### Technical Field

Various embodiments relate to a light emitting element, a method of manufacturing the light emitting element, and a display device including the light emitting element.

### Background Art

With the development of information technology, the importance of a display device, which is a connection medium between a user and information, has been increased. The display device may include a light emitting element that emits light. The light emitting element may be a diode including a P-type semiconductor, an N-type semiconductor, and a quantum well structure disposed therebetween.

To manufacture a high-performance display device having high resolution, it is demanded to reduce the size of the light emitting element and further improve emission efficiency of the light emitting element.

It is necessary to remove a process risk occurring during a process of manufacturing the light emitting element.

### Detailed Description of Invention

### Technical Problem

Various embodiments provide a light emitting element, a method of manufacturing the light emitting element, and a device including the light emitting element that are capable of reducing or minimizing a defect risk in a process of manufacturing the light emitting element and capable of improving emission efficiency.

However, embodiments of the disclosure are not limited to those set forth herein. The above and other embodiments will become more apparent to one of ordinary skill in the art to which the disclosure pertains by referencing the detailed description of the disclosure given below.

### Technical Solution

In an embodiment, a method of manufacturing a light emitting element may include: patterning a first semiconductor layer on a substrate; patterning a first insulating layer on a side surface of the first semiconductor layer; and forming an active layer and a second semiconductor layer on the first semiconductor layer.

In an embodiment, patterning the first semiconductor layer may include: forming a base semiconductor layer on the substrate; and etching at least a portion of the base semiconductor layer by using a mask exposing an upper surface of the base semiconductor layer.

In an embodiment, the patterning of the first semiconductor layer and the forming of the second semiconductor layer may be performed in separate processes.

In an embodiment, the forming of the active layer and the second semiconductor layer may include depositing the active layer and the second semiconductor layer. The depositing of the active layer and the second semiconductor layer may include individually patterning the active layer and the second semiconductor layer.

In an embodiment, the patterning of the first insulating layer may include exposing an upper surface of the first semiconductor layer from the first insulating layer.

In an embodiment, the forming of the active layer and the second semiconductor layer may include growing the active layer and the second semiconductor layer on the exposed upper surface of the first semiconductor layer.

In an embodiment, the insulating layer may cover the side surface of the first semiconductor layer such that the active layer and the second semiconductor layer may not be grown on the side surface of the first semiconductor layer.

In an embodiment, the method may further include patterning the second insulating layer. The patterning of the second insulating layer may include: disposing a first portion of the second insulating layer on the first insulating layer; and disposing a second portion of the second insulating layer on a side surface of the active layer and a side surface of the second semiconductor layer.

In an embodiment, the method may further include patterning an electrode layer on the second semiconductor layer after the patterning of the second insulating layer.

In an embodiment, the first semiconductor layer, the active layer, and the second semiconductor layer may form a semiconductor stack member. The first semiconductor layer may include first semiconductor layers adjacent to each other. The method may further include: forming a lower active layer and a lower second-semiconductor-layer between the first semiconductor layers adjacent to each other at a same time to forming the active layer and the second semiconductor layer; and separating the semiconductor stack member from the substrate. The separating of the semiconductor stack member includes individually separating the semiconductor stack member along a separation line that is a portion of the first semiconductor layer. The separation line may be defined at a position substantially identical to or higher than an uppermost surface of the lower second-semiconductor-layer.

In an embodiment, the method may further include forming an additional first-semiconductor-layer on the first semiconductor layer.

In an embodiment, the method may further include forming the active layer and the second semiconductor layer on the additional first-semiconductor-layer. The surface area (or surface size) of an upper surface of the first semiconductor layer, on which the additional first-semiconductor-layer grows, may be smaller than the surface area (or surface size) of a proximity surface between the additional first-semiconductor-layer and the active layer.

In an embodiment, a light emitting element may include: a semiconductor stack member including a first semiconductor layer, a second semiconductor layer, and an active layer disposed between the first semiconductor layer and the second semiconductor layer; and an insulating layer disposed on a side surface of the semiconductor stack member. The insulating layer may include a first insulating layer disposed on a side surface of the first semiconductor layer and exposing a side surface of the active layer or a side surface of the second semiconductor layer, and a second insulating layer disposed on the side surface of the semiconductor stack member. The second insulating layer may include a first portion not contacting the first semiconductor layer by the first insulating layer interposed between the first portion and the first semiconductor layer, and a second portion contacting the active layer and the second semiconductor layer.

In an embodiment, the active layer may include a quantum well layer including a first side surface, and a quantum barrier layer including a second side surface, and the first side surface and the second side surface may form an even plane.

In an embodiment, the first side surface and the second side surface may form a side surface that does not have any recess.

In an embodiment, the second insulating layer may form a stepped portion in an area between the first portion and the second portion of the second insulating layer.

In an embodiment, the insulating layer may have a first thickness in an area overlapping the first semiconductor layer, and may have a second thickness less than the first thickness in an area overlapping the active layer.

In an embodiment, the first insulating layer may not cover the side surface of the active layer and the side surface of the second semiconductor layer.

In an embodiment, the active layer and the first semiconductor layer may have a same cross-sectional size.

In an embodiment, the active layer may include an active surface facing the first semiconductor layer. The active surface may entirely cover the first semiconductor layer, and may include a portion of the active surface that does not contact the first semiconductor layer.

In an embodiment, the active layer may have a truncated shape.

In an embodiment, the first semiconductor layer may include a body overlapping the first insulating layer and the second insulating layer, and a protrusion protruding from the body.

In an embodiment, the light emitting element may further include a first end portion adjacent to the first semiconductor layer, a second end portion adjacent to the second semiconductor layer, and an auxiliary semiconductor layer disposed on the first insulating layer in an area adjacent to the first end portion and including a material identical to a material of the second semiconductor layer.

In an embodiment, the light emitting element may further include a first end portion adjacent to the first semiconductor layer, a second end portion adjacent to the second semiconductor layer, an electrode layer disposed on the second semiconductor layer, and an auxiliary electrode layer disposed on the first insulating layer in an area adjacent to the first end portion and including a material substantially identical to a material of the electrode layer.

An embodiment may provide a display device including: a base layer; and a light-emitting-element layer disposed on the base layer, and including the light emitting element. The light-emitting-element layer may include: a first electrode and a second electrode spaced apart from each other; an anode connection electrode electrically connected to a first end portion of the light emitting element, and a cathode connection electrode electrically connected to a second end portion of the light emitting element. The light emitting element may be aligned between the first electrode and the second electrode.

### Advantageous Effects

Various embodiments may provide a light emitting element, a method of manufacturing the light emitting element, and a device including the light emitting element that are capable of reducing or minimizing a defect risk in a process of manufacturing the light emitting element and capable of improving emission efficiency.

### Description of Drawings

FIGS. 1 to 3 are schematic views illustrating a light emitting element in accordance with a first embodiment.
FIGS. 4 and 5 are schematic views illustrating a light emitting element in accordance with a second embodiment.
FIG. 6 is a schematic cross-sectional view illustrating a light emitting element in accordance with a third embodiment.
FIG. 7 is a schematic cross-sectional view illustrating a light emitting element in accordance with a fourth embodiment.
FIG. 8 is a schematic cross-sectional view illustrating a light emitting element in accordance with a fifth embodiment.
FIG. 9 is a schematic cross-sectional view illustrating a light emitting element in accordance with a sixth embodiment.
FIG. 10 is a schematic plan view illustrating a display device in accordance with an embodiment.
FIG. 11 is a schematic cross-sectional view illustrating a display device in accordance with an embodiment.
FIG. 12 is a schematic cross-sectional view illustrating connection electrodes and a light emitting element in accordance with an embodiment.
FIG. 13 is a schematic flowchart illustrating a method of manufacturing a light emitting element in accordance with one or more embodiments.
FIGS. 14, 15, and 19 to 28 are schematic cross-sectional views illustrating a method of manufacturing a light emitting element in accordance with one or more embodiments.
FIGS. 16 to 18 are schematic plan views each illustrating a method of manufacturing a light emitting element in accordance with an embodiment.
FIG. 29 is a schematic flowchart illustrating a method of manufacturing the light emitting element in accordance with the fifth embodiment.
FIGS. 30 to 32 are schematic cross-sectional views illustrating the method of manufacturing the light emitting element in accordance with the fifth embodiment.
FIG. 33 is a schematic flowchart illustrating a method of manufacturing the light emitting element in accordance with the sixth embodiment.
FIGS. 34 to 38 are schematic cross-sectional views illustrating the method of manufacturing the light emitting element in accordance with the sixth embodiment.

### Modes of the Invention

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Various embodiments relate to a method of manufacturing a light emitting element, the light emitting element, and a display device including the light emitting element. Hereinafter, a light emitting element, a method of manufacturing the light emitting element, and a display device including the light emitting element in accordance with an embodiment will be described with reference to the attached drawings.

A light emitting element LD in accordance with an embodiment may be manufactured without an etching process performed for an active layer AL. Consequently, a defect risk in manufacturing the light emitting element LD may be reduced, so that the emission efficiency may be enhanced.

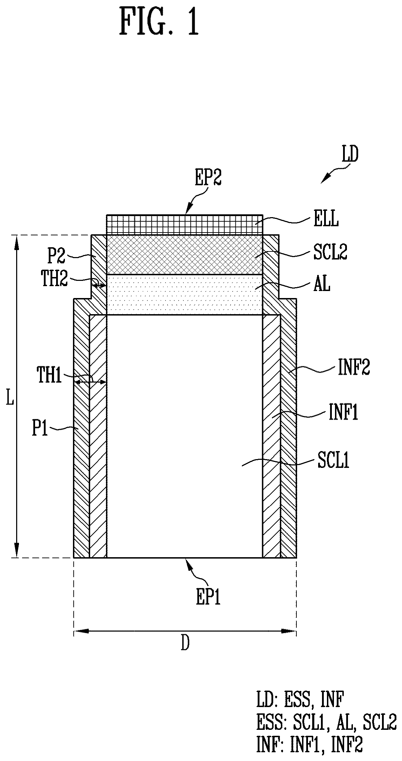

A light emitting element LD in accordance with one or more embodiments will be described with reference to FIGS. 1 to 9.

A light emitting element LD in accordance with a first embodiment will be described with reference to FIGS. 1 to 3.

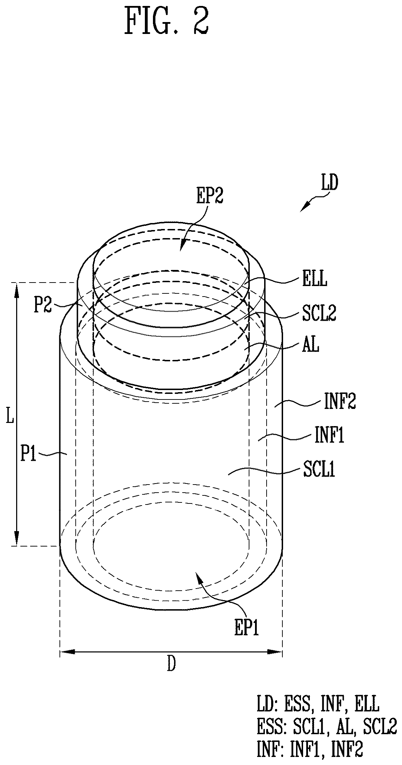

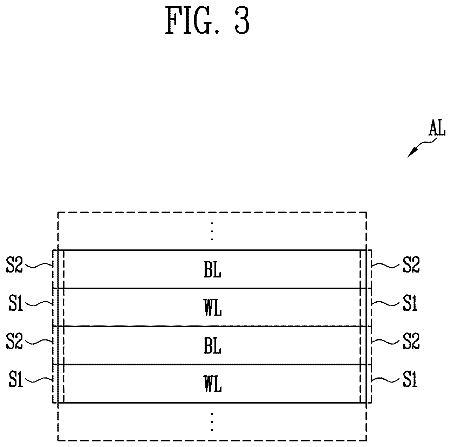

FIGS. 1 to 3 are schematic views each illustrating the light emitting element LD in accordance with the first embodiment. FIG. 1 is a schematic cross-sectional view illustrating the light emitting element LD in accordance with the first embodiment. FIG. 2 is a schematic perspective view illustrating the light emitting element LD in accordance with the first embodiment. FIG. 3 is a schematic cross-sectional view illustrating an active layer AL of the light emitting element LD in accordance with the first embodiment.

The light emitting element LD may emit light. The light emitting element LD may include a semiconductor stack member ESS and an insulating layer INF. The semiconductor stack member ESS may include a first semiconductor layer SCL1, a second semiconductor layer SCL2, and an active layer AL disposed between the first semiconductor layer SCL1 and the second semiconductor layer SCL2. In an embodiment, the light emitting element LD may further include an electrode layer ELL.

In an embodiment, the first semiconductor layer SCL1, the active layer AL, and the second semiconductor layer SCL2 may be successively stacked in a longitudinal direction of the light emitting element LD, which extends in the direction of the length L of the light emitting element LD.

The light emitting element LD may have various shapes. For example, the light emitting element LD may have a pillar-like shape extending in a direction (e.g., the longitudinal direction). In an embodiment, the cross-sectional shape of the light emitting element LD is not limited. For example, the cross-sectional shape of the light emitting element LD may have a circular shape or an elliptical shape. In another example, the cross-section of the light emitting element LD may have an n-polygonal shape, where n is an integer of 3 or more.

The light emitting element LD may include a first end portion EP1 and a second end portion EP2. In an embodiment, the first semiconductor layer SCL1 may be adjacent to the first end portion EP1 of the light emitting element LD. The second semiconductor layer SCL2 may be adjacent to the second end portion EP2. In an embodiment, the electrode layer ELL may be adjacent to the second end portion EP2.

The light emitting element LD may have various sizes. In an embodiment, a diameter D (or a width) of the light emitting element LD and the length L of the light emitting element LD each may range from the nanoscale to the microscale. However, embodiments are not limited thereto.

The first semiconductor layer SCL1 may include a first conductive semiconductor. The first semiconductor layer SCL1 may be disposed on the active layer AL and include a semiconductor layer having a type different from that of the second semiconductor layer SCL2. For example, the first semiconductor layer SCL1 may include an N-type semiconductor layer. For example, the first semiconductor layer SCL1 may include one or more selected from the group consisting of InAlGaN, GaN, AlGaN, InGaN, AIN, AlGaInP, GaAs, and InN, and may include an N-type semiconductor layer doped with a first conductive dopant such as Si, Ge, and Sn. However, embodiments are not limited thereto. The first semiconductor layer SCL1 may include various materials.

The active layer AL may be disposed between the first semiconductor layer SCL1 and the second semiconductor layer SCL2. The position of the active layer AL may be changed in various ways according to the type of the light emitting element LD.

The active layer AL may include a single-quantum well structure or a multi-quantum well structure.

The active layer AL may include a quantum well layer WL and a quantum barrier layer BL. The quantum barrier layer BL may form a quantum barrier for forming the quantum well structure. The quantum well layer WL may form a quantum well for forming the quantum well structure. For example, the quantum barrier layer BL may include GaN, and the quantum well layer WL may include InGaN. However, embodiments are not limited thereto.

The second semiconductor layer SCL2 may include a second conductive semiconductor. The second semiconductor layer SCL2 may be disposed on the active layer AL and include a semiconductor layer of a type different from that of the first semiconductor layer SCL1. For example, the second semiconductor layer SCL2 may include a P-type semiconductor layer. For example, the second semiconductor layer SCL2 may include one or more semiconductor materials selected from the group consisting of InAlGaN, GaN, AlGaN, InGaN, AIN, AlGaInP, GaAs, and InN, and may include a P-type semiconductor layer doped with a second conductive dopant such as Ga, B, and Mg. However, embodiments are not limited thereto. The second semiconductor layer SCL2 may include various materials.

In an embodiment, the active layer AL and the first semiconductor layer SCL1 may be adjacent to each other (e.g., may contact each other). In an embodiment, a surface area (or surface size) of a first surface of the active layer AL that faces the first semiconductor layer SCL1 and a surface area (or surface size) of a surface of the first semiconductor layer SCL1 that faces the active layer AL may be the same as each other. For example, as the active layer AL is grown on an upper surface of the first semiconductor layer SCL1 after the first semiconductor layer SCL1 is formed, the surface area (or surface size) of the surface of the active layer AL and the surface area (or surface size) of the surface of the first semiconductor layer SCL1 may be the same as each other.

In an embodiment, the active layer AL and the second semiconductor layer SCL2 may be adjacent to each other (e.g., may contact each other). In an embodiment, a surface area (or surface size) of a second surface of the active layer AL that faces the second semiconductor layer SCL2 and a surface area (or surface size) of a surface of the second semiconductor layer SCL2 that faces the active layer AL may be the same as each other.

In an embodiment, the active layer AL and the second semiconductor layer SCL2 may have a uniform cross-sectional area (or uniform cross-sectional size), e.g., in the lateral direction (or width direction). For example, the active layer AL and the second semiconductor layer SCL2 may be grown on the first semiconductor layer SCL1, and formed to have a substantially uniform cross-sectional area (or uniform cross-sectional size), e.g., in the lateral direction (or width direction).

The active layer AL may include a side surface, a curved portion of which is minimized, and which thus has a substantially even surface. For example, the quantum well layer WL may have a first side surface S1, and the quantum barrier layer BL may have a second side surface S2. For example, the first side surface S1 and the second side surface S2 may have an even plane (e.g., flat surface).

For example, each of the first side surface S1 and the second side surface S2 may not have a groove. In an embodiment, the first side surface S1 and the second side surface S2 may form a side surface (e.g., an even flat side surface) which does not have a recess.

In the description, the term "side surface" may mean an area of an object (e.g., the semiconductor stack member ESS, the active layer AL, the first semiconductor layer SCL1, the second semiconductor layer SCL2, or the like) including a portion of a remaining area except for an upper surface and a lower surface of the object. For example, the upper surface and the lower surface of the object may mean surfaces corresponding to the first end portion EP1 or the second end portion EP2 of the light emitting element LD (or the semiconductor stack member ESS). In an embodiment, the side surface may mean a portion of the outer surface of the object that is defined in an area between the first end portion EP1 and the second end portion EP2 of the light emitting element LD (or the semiconductor stack member ESS).

For example, the active layer AL may be manufactured without performing a separate etching process. Thus, in an embodiment, a defect may not be formed in the active layer AL, so that the emission efficiency of the light emitting element LD may be enhanced.

In the case where a voltage of a threshold voltage or more is applied between the first end portion EP1 and the second end portion EP2 of the light emitting element LD, an electron-hole pair in the active layer AL may be recombined, and the light emitting element LD may emit light. Since light emission of the light emitting element LD is controlled based on the foregoing principle, the light emitting element LD may be used as a light source in various devices.

The insulating layer INF may be disposed on a side surface of the semiconductor stack member ESS. The insulating layer INF may enclose (or surround) at least a portion of the side surface of the active layer AL, and may also enclose (or surround) a portion of each of the first semiconductor layer SCL1 and the second semiconductor layer SCL2.

The insulating layer INF may include a first insulating layer INF1 and a second insulating layer INF2. In an embodiment, the insulating layer INF may include inorganic material.

In an embodiment, the first insulating layer INF1 and the second insulating layer INF2 may include the same inorganic material. In an embodiment, the first insulating layer INF1 and the second insulating layer INF2 may respectively include different inorganic materials.

In an embodiment, inorganic material may include one or more selected from the group consisting of silicon oxide (SiOx), silicon nitride (SiNx), silicon oxynitride (SiOxNy), aluminium oxide (AlxOy), zirconium oxide (ZrxOy), hafnium oxide (HfxOy), and titanium oxide (TiOx).

The insulating layer INF may expose the first end portion EP1 and the second end portion EP2 of the light emitting element LD that have different polarities. For example, the insulating layer INF may expose respective end portions of the electrode layer ELL and the first semiconductor layer SCL1 that are adjacent to the first end portion EP1 and the second end portion EP2 of the light emitting element LD.

The insulating layer INF may ensure electrical stability of the light emitting element LD. Furthermore, the insulating layer INF may minimize surface defects of the light emitting element LD so that the lifetime and the efficiency of the light emitting element LD may be enhanced. In the case where a plurality of light emitting elements LD are disposed adjacent to each other, the insulating layer INF may prevent a short-circuit defect between the light emitting elements LD from occurring.

The first insulating layer INF1 and the second insulating layer INF2 may be formed by different processes. For example, the first insulating layer INF1 may be formed before the second insulating layer INF2 is formed. In an embodiment, the first insulating layer INF1 may be patterned before the active layer AL and the second semiconductor layer SCL2 are formed. The second insulating layer INF2 may be patterned after the active layer AL and the second semiconductor layer SCL2 are formed.

In an embodiment, the first insulating layer INF1, which forms an internal structure of the insulating layer INF, may be selectively disposed at a position in the semiconductor stack member ESS.

For example, a stepped portion defined by the second insulating layer INF2 may be formed between a first side surface area of the semiconductor stack member ESS on which the first insulating layer INF1 is disposed and a second side surface area of the semiconductor stack member ESS on which the first insulating layer INF1 is not disposed.

For example, as the second insulating layer INF2 is disposed on an overall surface of the side surface of the semiconductor stack member ESS, the second insulating layer INF2 may form a stepped portion between the first side surface area of the semiconductor stack member ESS on which the first insulating layer INF1 is disposed and the second side surface area of the semiconductor stack member ESS on which the first insulating layer INF1 is not disposed.

In an embodiment, the thickness of the insulating layer INF in an area corresponding to the position of the first semiconductor layer SCL1 may be greater than that of the insulating layer INF in an area corresponding to the position of the second semiconductor layer SCL2 and/or the active layer AL. For example, the insulating layer INF may have a first thickness TH1 in an area overlapping the first semiconductor layer SCL1, and may have, in an area overlapping the active layer AL or the second semiconductor layer SCL2, a second thickness TH2 less than the first thickness TH1.

The first insulating layer INF1 may be disposed on a side surface of the first semiconductor layer SCL1. For example, the first insulating layer INF1 may cover the side surface of the first semiconductor layer SCL1, and may not cover respective side surfaces of the active layer AL and the second semiconductor layer SCL2.

The first insulating layer INF1 may be manufactured before the active layer AL and the second semiconductor layer SCL2 are formed after the first semiconductor layer SCL1 is formed. Hence, the first insulating layer INF1 may determine positions at which the active layer AL and the second semiconductor layer SCL2 are to be formed.

The second insulating layer INF2 may be disposed on the respective side surfaces of the first semiconductor layer SCL1, the active layer AL, and the second semiconductor layer SCL2. The second insulating layer INF2 may be disposed on the first insulating layer INF1. For example, the second insulating layer INF2 may cover the respective side surfaces of the first semiconductor layer SCL1, the active layer AL, and the second semiconductor layer SCL2.

The second insulating layer INF2 may include a first portion P1 which overlaps the first semiconductor layer SCL1 in a cross-sectional direction of the light emitting element LD (or in a lateral direction extending in the direction of the diameter D (or width) of the light emitting element LD), and a second portion P2 which overlaps the active layer AL or the second semiconductor layer SCL2 in the cross-sectional direction of the light emitting element LD (or in a lateral direction extending in the direction of the diameter D (or width) of the light emitting element LD).

The first portion P1 of the second insulating layer INF2 may not contact the first semiconductor layer SCL1 by the first insulating layer INF1 interposed therebetween. The second portion P2 of the second insulating layer INF2 may contact the active layer AL and the second semiconductor layer SCL2.

The first portion P1 of the second insulating layer INF2 may overlap the first insulating layer INF1. The first portion P1 of the second insulating layer INF2 may be disposed on the first insulating layer INF1. In an embodiment, the first portion P1 of the second insulating layer INF2 may overlap the first semiconductor layer SCL1 and the first insulating layer INF1, and may not overlap the active layer AL and the second semiconductor layer SCL2.

The second portion P2 of the second insulating layer INF2 may not overlap the first insulating layer INF1. The second portion P2 of the second insulating layer INF2 may be disposed on the active layer AL and the second semiconductor layer SCL2. In an embodiment, the second portion P2 of the second insulating layer INF2 may overlap the active layer AL and the second semiconductor layer SCL2, and may not overlap the first semiconductor layer SCL1.

A portion of the second insulating layer INF2 may not contact the semiconductor stack member ESS, and another portion of the second insulating layer INF2 may contact the semiconductor stack member ESS. For example, the first portion P1 of the second insulating layer INF2 may be spaced apart from the semiconductor stack member ESS by the first insulating layer INF1. The second portion P2 of the second insulating layer INF2 may contact the semiconductor stack member ESS. For example, the second portion P2 of the second insulating layer INF2 may contact the active layer AL and the second semiconductor layer SCL2.

The second portion P2 of the second insulating layer INF2 may form a contact surface with the active layer AL or the second semiconductor layer SCL2. In an embodiment, a surface of the active layer AL that faces the second insulating layer INF2 may include a substantially even surface. Referring to FIG. 3, the active layer AL may include a first side surface S1 and a second side surface S2. The first side surface S1 and the second side surface S2 may face the second portion P2 of the second insulating layer INF2. In an embodiment, the first side surface S1 and the second side surface S2 of the active layer AL may contact the second insulating layer INF2.

The electrode layer ELL may be disposed on the second semiconductor layer SCL2. The electrode layer ELL may be adjacent to the second end portion EP2.

The electrode layer ELL may be connected (e.g., electrically connected) to the second semiconductor layer SCL2. A portion of the electrode layer ELL may be exposed. For example, the insulating layer INF may expose a surface of the electrode layer ELL. The electrode layer ELL may be exposed in an area corresponding to the second end portion EP2. In an embodiment, a side surface of the electrode layer ELL may be exposed.

In an embodiment, the electrode layer ELL may be an ohmic contact electrode. However, embodiments are not limited thereto. For example, the electrode layer ELL may be a Schottky contact electrode.

In an embodiment, the electrode layer ELL may be substantially transparent. For example, the electrode layer ELL may include indium tin oxide (ITO). Hence, the electrode layer ELL may transmit emitted light therethrough. However, embodiments are not limited thereto. In an embodiment, the electrode layer ELL may include one or more selected from the group consisting of chromium (Cr), titanium (Ti), aluminium (Al), gold (Au), nickel (Ni), and oxide or an alloy thereof.

The structure of the light emitting element LD in accordance with an embodiment is not limited thereto. For example, the light emitting element LD may include a superlattice layer disposed between the first semiconductor layer SCL1 and the active layer AL, and/or a strain relief layer disposed between the active layer AL and the second semiconductor layer SCL2.

In an embodiment, the superlattice layer may have a structure formed by alternately stacking two or more kinds of layers having different compositions. For example, the superlattice layer may have a structure in which GaN layers and InGaN layers are alternately stacked. In an embodiment, the superlattice layer may relieve (or reduce) stress between the first semiconductor layer SCL1 and the active layer AL. An electron blocking layer may block at least some of the electrons between the active layer AL and the second semiconductor layer SCL2 so that the efficiency of recombination of electron-hole pairs for light emission may be enhanced.

In an embodiment, the electron blocking layer may include a material having a band-gap energy larger than that of the second semiconductor layer SCL2 so as to prevent an overflow of electrons. For example, the electron blocking layer may include AlGaN doped with Mg.

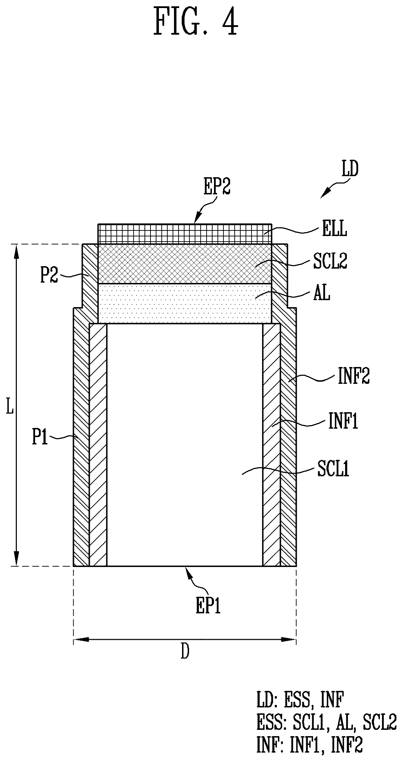

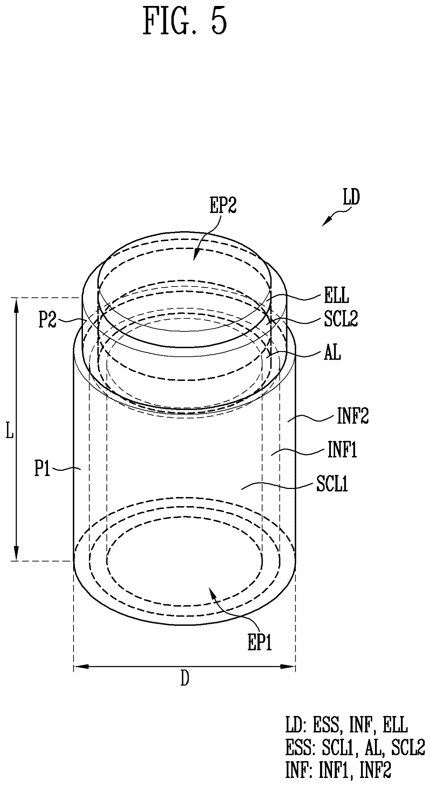

A light emitting element LD in accordance with a second embodiment will be described with reference to FIGS. 4 and 5. The feature of the light emitting element LD in accordance with the second embodiment will be described, focused on differences from that of the first embodiment described above. The redundant description, which is similar to or the same as that of the embodiments described above, will be simplified, or may be omitted for descriptive convenience.

FIGS. 4 and 5 are schematic views illustrating the light emitting element LD in accordance with the second embodiment. FIG. 4 is a schematic cross-sectional view illustrating the light emitting element LD in accordance with the second embodiment. FIG. 5 is a schematic perspective view illustrating the light emitting element LD in accordance with the second embodiment.

The light emitting element LD in accordance with the second embodiment is different from the light emitting element LD in accordance with the first embodiment in that the active layer AL and the second semiconductor layer SCL2 each have a cross-sectional area greater than that of the first semiconductor layer SCL1.

The active layer AL may include an active surface facing the first semiconductor layer SCL1. The first semiconductor layer SCL1 may include a semiconductor surface facing the active layer AL. For example, the active surface of the active layer AL may have a surface area (or surface size) greater than that of the semiconductor surface of the first semiconductor layer SCL1.

For example, the active surface of the active layer AL may cover an overall surface of the semiconductor surface of the first semiconductor layer SCL1. The active surface of the active layer AL may include the semiconductor surface of the first semiconductor layer SCL1, and may include some areas which do not contact the semiconductor surface of the first semiconductor layer SCL1.

The second semiconductor layer SCL2 may include a semiconductor surface facing the first semiconductor layer SCL1. For example, the semiconductor surface of the second semiconductor layer SCL2 may have a surface area (or surface size) greater than that of the semiconductor surface of the first semiconductor layer SCL1. In an embodiment, the semiconductor surface of the second semiconductor layer SCL2 may have a surface area (or surface size) corresponding to that of the active surface of the active layer AL. In an embodiment, the surface area of a surface of the electrode layer ELL may have a surface area (or surface size) corresponding to that of the active surface of the active layer AL.

In an embodiment, the active surface of the active layer AL may overlap at least a portion of the first insulating layer INF1. For example, a portion of the active surface of the active layer AL may not contact the first semiconductor layer SCL1, may contact the first insulating layer INF1 (e.g., an upper surface of the first insulating layer INF1 in the longitudinal direction), and may overlap a side surface of the second insulating layer INF2 in a thickness direction of the second insulating layer INF2.

For example, as the active surface of the active layer AL covers an overall surface of the semiconductor surface of the first semiconductor layer SCL1, an electrical contact area between the first semiconductor layer SCL1 and the active layer AL may be reliably formed.

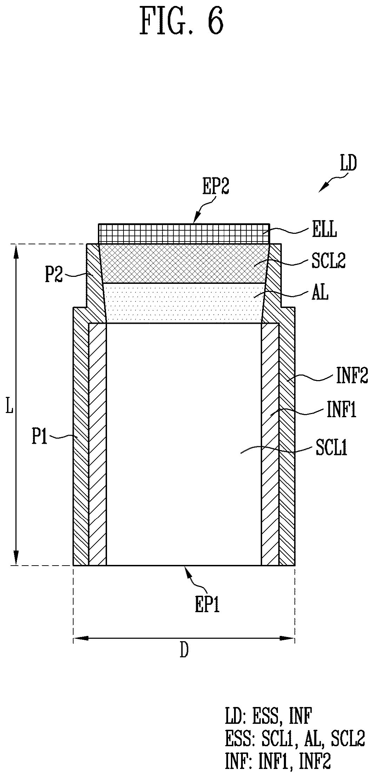

A light emitting element LD in accordance with a third embodiment will be described with reference to FIG. 6. The feature of the light emitting element LD in accordance with the third embodiment will be described, focused on differences from that of the first embodiment described above. The redundant description, which is similar to or the same as that of the embodiments described above, will be simplified, or may be omitted for descriptive convenience.

FIG. 6 is a schematic cross-sectional view illustrating the light emitting element LD in accordance with the third embodiment.

The light emitting element LD in accordance with the third embodiment is different from the light emitting element LD in accordance with the first embodiment in that the cross-sectional area of each of the active layer AL and the second semiconductor layer SCL2 is increased in a direction in which the light emitting element LD is adjacent to the second end portion EP2.

In an embodiment, the active layer AL and the second semiconductor layer SCL2 each may have an approximately truncated shape such as a truncated cone shape and a truncated n-polygon shape, where n is a natural number of 3 or more.

For example, the active layer AL may have a cross-sectional area which increases in a direction from an area adjacent to the first end portion EP1 toward an area adjacent to the second end portion EP2. The second semiconductor layer SCL2 may have a cross-sectional area which increases in a direction from an area adjacent to the first end portion EP1 toward an area adjacent to the second end portion EP2.

In an embodiment, the second portion P2 of the second insulating layer INF2 may have a thickness complementary to the cross-sectional areas of the active layer AL and the second semiconductor layer SCL2. For example, the second portion P2 of the second insulating layer INF2 may have a thickness which increases as being closer to the first end portion EP1 toward the second end portion EP2. Hence, the light emitting element LD may have a substantially uniform cross-sectional area in an area corresponding to the active layer AL and the second semiconductor layer SCL2, e.g., in the lateral direction (or width direction).

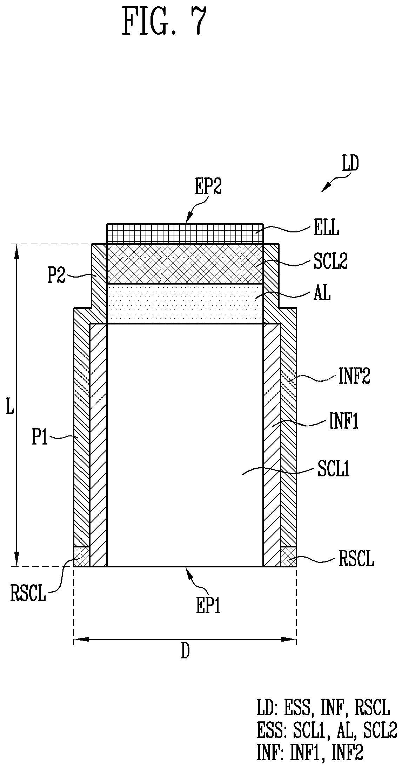

A light emitting element LD in accordance with a fourth embodiment will be described with reference to FIG. 7. The feature of the light emitting element LD in accordance with the fourth embodiment will be described, focused on differences from that of the embodiments described above. The redundant description, which is similar to or the same as that of the embodiments described above will be simplified, or may be omitted for descriptive convenience.

FIG. 7 is a schematic cross-sectional view illustrating the light emitting element LD in accordance with the fourth embodiment.

The light emitting element LD in accordance with the fourth embodiment is different from the light emitting elements LD in accordance with the above embodiments in that the light emitting element LD in accordance with the fourth embodiment further includes an auxiliary semiconductor layer RSCL.

The auxiliary semiconductor layer RSCL may be disposed on the first insulating layer INF1 in the same manner as that of the first portion P1 of the second insulating layer INF2. For example, the auxiliary semiconductor layer RSCL may be disposed on a peripheral portion of the first insulating layer INF1. The auxiliary semiconductor layer RSCL may overlap the semiconductor stack member ESS in a radial direction of the light emitting element LD.

The auxiliary semiconductor layer RSCL may be disposed on the first insulating layer INF1. For example, the auxiliary semiconductor layer RSCL and the second insulating layer INF2 may be adjacent to each other, may contact each other, and may be disposed on the same layer (e.g., the first insulating layer INF1).

The auxiliary semiconductor layer RSCL may be disposed on the first insulating layer INF1 in an area adjacent to the first end portion EP1 of the light emitting element LD. For example, the auxiliary semiconductor layer RSCL may be disposed on a first insulating portion of the first insulating layer INF1, and the first portion P1 of the second insulating layer INF2 may be disposed on a second insulating portion of the first insulating layer INF1. For example, the first insulating portion of the first insulating layer INF1 may be more adjacent to the first end portion EP1 of the light emitting element LD than to the second insulating portion of the first insulating layer INF1, and may not overlap the second insulating portion of the first insulating layer INF1 in the cross-sectional direction of the light emitting element LD (or in a lateral direction extending in the direction of the diameter D (or width) of the light emitting element LD).

The auxiliary semiconductor layer RSCL and the second semiconductor layer SCL2 may include the same material. For example, the auxiliary semiconductor layer RSCL may include a P-type semiconductor material, and may include one or more among the materials described above pertaining to the second semiconductor layer SCL2. The auxiliary semiconductor layer RSCL and the second semiconductor layer SCL2 may be grown (or formed) by the same process. Therefore, in an embodiment, the light emitting element LD including the auxiliary semiconductor layer RSCL may be manufactured without an additional process of manufacturing the auxiliary semiconductor layer RSCL.

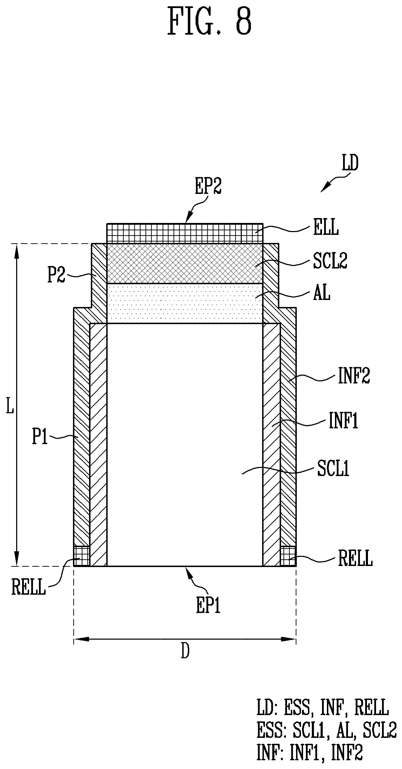

A light emitting element LD in accordance with a fifth embodiment will be described with reference to FIG. 8. The feature of the light emitting element LD in accordance with the fifth embodiment will be described, focused on differences from that of the embodiments described above. The redundant description, which is similar to or the same as that of the embodiments described above will be simplified, or may be omitted for descriptive convenience.

FIG. 8 is a schematic cross-sectional view illustrating the light emitting element LD in accordance with the fifth embodiment.

The light emitting element LD in accordance with the fifth embodiment is different from the light emitting elements LD in accordance with the above embodiments in that the light emitting element LD in accordance with the fifth embodiment further includes an auxiliary electrode layer RELL. The auxiliary electrode layer RELL may be disposed at a position corresponding to the auxiliary semiconductor layer RSCL described above.

The auxiliary electrode layer RELL may be disposed on the first insulating layer INF1 in the same manner as that of the first portion P1 of the second insulating layer INF2. For example, the auxiliary electrode layer RELL may be disposed on a peripheral portion of the first insulating layer INF1. The auxiliary electrode layer RELL may overlap the semiconductor stack member ESS in the radial direction of the light emitting element LD.

The auxiliary electrode layer RELL may be disposed on the first insulating layer INF1. For example, the auxiliary electrode layer RELL and the second insulating layer INF2 may be adjacent to each other, may contact each other, and may be disposed on the same layer (e.g., the first insulating layer INF1).

The auxiliary electrode layer RELL may be disposed on the first insulating layer INF1 in an area adjacent to the first end portion EP1 of the light emitting element LD. For example, the auxiliary electrode layer RELL may be disposed on the first insulating portion of the first insulating layer INF1, and the first portion P1 of the second insulating layer INF2 may be disposed on the second insulating portion of the first insulating layer INF1. For example, the first insulating portion of the first insulating layer INF1 may be more adjacent to the first end portion EP1 of the light emitting element LD than to the second insulating portion of the first insulating layer INF1, and may not overlap the second insulating portion of the first insulating layer INF1 in the cross-sectional direction of the light emitting element LD (or in a lateral direction extending in the direction of the diameter D (or width) of the light emitting element LD).

The auxiliary electrode layer RELL and the electrode layer ELL may include the same material. For example, the auxiliary electrode layer RELL may include a conductive material, and may include one or more among materials described above regarding the electrode layer ELL. The auxiliary electrode layer RELL and the electrode layer ELL may be deposited (or formed) by the same process. Therefore, in an embodiment, the light emitting element LD including the auxiliary electrode layer RELL may be manufactured without an additional process of manufacturing the auxiliary electrode layer RELL. In an embodiment, the auxiliary electrode layer RELL may assist the light emitting element LD to be more reliably connected (e.g., electrically connected) to other lines. For example, the first end portion EP1 of the light emitting element LD may be connected (e.g., electrically connected) to a cathode connection electrode CNEC. For example, the auxiliary electrode layer RELL may assist in electrical connection between the first end portion EP1 of the light emitting element LD and the cathode connection electrode CNEC.

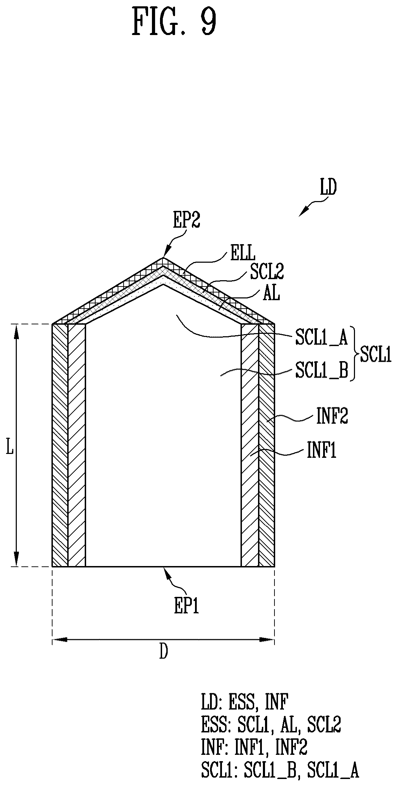

A light emitting element LD in accordance with a sixth embodiment will be described with reference to FIG. 9. The feature of the light emitting element LD in accordance with the sixth embodiment will be described, focused on differences from that of the first embodiment described above. The redundant description, which is similar to or the same as that of the embodiments described above will be simplified, or may be omitted for descriptive convenience.

FIG. 9 is a schematic cross-sectional view illustrating the light emitting element LD in accordance with the sixth embodiment.

The light emitting element LD in accordance with the sixth embodiment is different from the light emitting element LD in accordance with the first embodiment in that the first semiconductor layer SCL1 has a partially protruding portion.

For example, the first semiconductor layer SCL1 may include a body SCL1_B and a protrusion SCL1_A.

The body SCL1_B may be a portion of the first semiconductor layer SCL1 and overlap the first insulating layer INF1 and the second insulating layer INF2. The body SCL1_B may correspond to an entire structure of the first semiconductor layer SCL1 described above.

The protrusion SCL1_A may be a semiconductor layer formed (e.g., grown) on the body SCL1_B. The protrusion SCL1_A may have a shape in which at least a portion thereof protrudes. For example, the protrusion SCL1_A may have a conical shape, of which one area sharply protrudes, but embodiments are not limited thereto.

In an embodiment, the active layer AL, the second semiconductor layer SCL2, and the electrode layer ELL each may have a shape corresponding to an outer shape of the protrusion SCL1_A.

The protrusion SCL1_A may be adjacent to the active layer AL. For example, the protrusion SCL1_A may be directly adjacent to the active layer AL. The active layer AL may have an active surface which is directly adjacent to the protrusion SCL1_A. For example, a proximity surface area between the active layer AL and the first semiconductor layer SCL1 may be increased, so that the emission efficiency of the light emitting element LD may be improved.

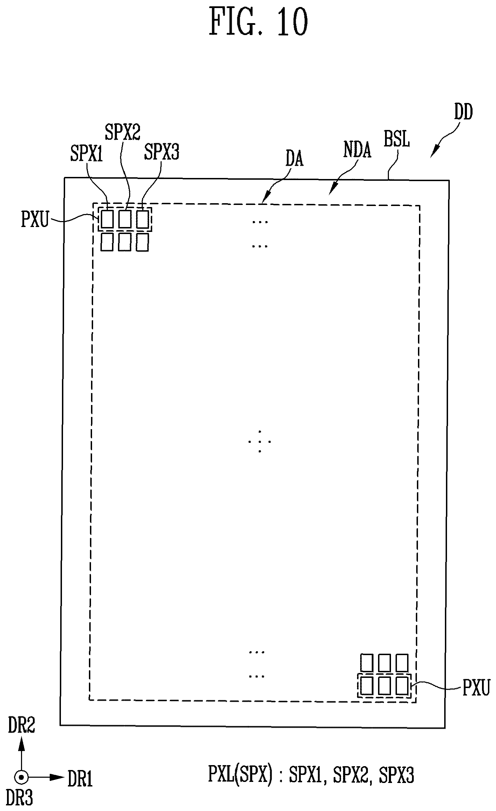

A display device DD including the light emitting element LD in accordance with an embodiment will be described with reference to FIGS. 10 to 12. The redundant description, which is similar to or the same as that of the embodiments described above will be simplified, or may be omitted for descriptive convenience.

FIG. 10 is a schematic plan view illustrating a display device in accordance with an embodiment.

The display device DD may emit light. The display device DD may include a light emitting element LD. In an embodiment, the display device DD may be provided in various shapes. For example, the display device DD may be applied to a smart phone, a notebook computer, a table personal computer (PC), a wearable device (e.g., a head-mounted device, a smart watch, smart glasses, etc.), a television, or an in-vehicle infotainment system, and the like, and may be applied to various other embodiments.

Referring to FIG. 10, the display device DD may include a base layer BSL and pixels PXL disposed on the base layer BSL. The display device DD may further include a driving circuit component (e.g., a scan driver and a data driver), lines, and pads which are provided to drive the pixels PXL.

The display device DD may include a display area DA and a non-display area NDA. The non-display area NDA may refer to an area other than the display area DA. The non-display area NDA may enclose (or surround) at least a portion of the display area DA.

The base layer BSL may form a base of the display device DD. The base layer BSL may be a rigid or flexible substrate or film. For example, the base layer BSL may be a rigid substrate made of glass or reinforced glass, a flexible substrate (or a thin film) formed of plastic or metal, or at least one insulating layer. The material and/or properties of the base layer BSL are not limited. In an embodiment, the base layer BSL may be substantially transparent. For example, the words "substantially transparent" may mean that light can pass through the base layer BSL with a transmittance of a certain value or more. In an embodiment, the base layer BSL may be translucent or opaque. Furthermore, the base layer BSL may include reflective material.

The display area DA may refer to an area in which the pixels PXL are disposed. The non-display area NDA may refer to an area in which the pixels PXL are not disposed. The driving circuit component, the lines, and the pads which are connected to the pixels PXL of the display area DA may be disposed in the non-display area NDA.

In an embodiment, pixels PXL (or sub-pixels SPX) may be arranged according to a stripe or PENTILETM arrangement structure. However, embodiments are not limited thereto.

In an embodiment, each pixel PXL may include a light emitting element LD. The pixel PXL (or sub-pixels SPX) may include a first sub-pixel SPX1, a second sub-pixel SPX2, and a third sub-pixel SPX3. At least one first sub-pixel SPX1, at least one second sub-pixel SPX2, and at least one third sub-pixel SPX3 may form a pixel unit PXU which may emit various colors of light.

For example, each of the first sub-pixel SPX1, the second sub-pixel SPX2, and the third sub-pixel SPX3 may emit a color of light. For instance, the first sub-pixel SPX1 may be a red pixel that emits red (e.g., first color) light, the second sub-pixel SPX2 may be a green pixel that emits green (e.g., second color) light, and the third sub-pixel SPX3 may be a blue pixel that emits blue (e.g., third color) light. The color, type, and/or number of the first sub-pixel SPX1, the second sub-pixel SPX2, and the third sub-pixel SPX3 which form each pixel unit PXU is not limited to a specific example.

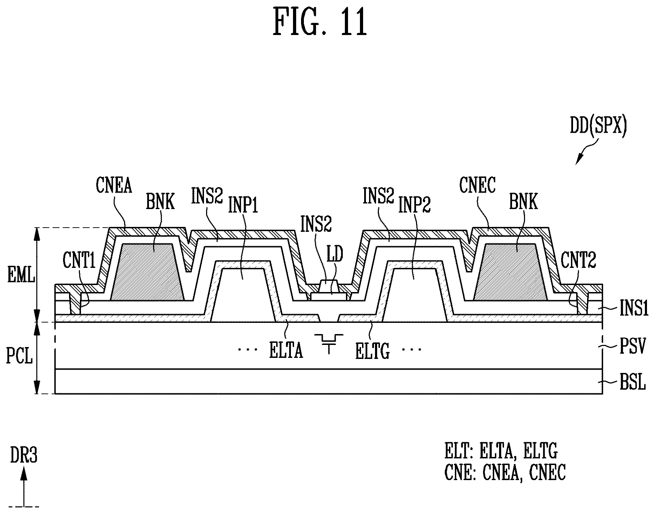

FIG. 11 is a schematic cross-sectional view illustrating a display device in accordance with an embodiment. FIG. 11 illustrates a pixel circuit layer PCL including a pixel circuit and a light-emitting-element layer EML on which the light emitting elements LD are disposed.

Referring to FIG. 11, the display device DD may include the pixel circuit layer PCL and the light-emitting-element layer EML.

The pixel circuit layer PCL may be a layer including a pixel circuit that drives the light emitting elements LD. The pixel circuit layer PCL may include a base layer BSL, metal layers provided to form pixel circuits, and insulating layers disposed between the metal layers. In an embodiment, the base layer BSL may form a base surface for supporting the display device DD.

In an embodiment, each of the pixel circuits may include a thin film transistor. The pixel circuits each may further include a storage capacitor. The pixel circuits may be connected (e.g., electrically connected) to the light emitting elements LD, and may provide electrical signals controlling the light emitting elements LD to emit light.

The light-emitting-element layer EML may be disposed on the pixel circuit layer PCL. The light-emitting-element layer EML may include first and second insulating pattern layers INP1 and INP2, an alignment electrode layer ELT, a first insulating layer INS1, a bank BNK, a light emitting element LD, a second insulating layer INS2, and a connection electrode layer CNE.

The first and second insulating pattern layers INP1 and INP2 may be disposed on a passivation layer PSV. Each of the first and second insulating pattern layers INP1 and INP2 may have various shapes. In an embodiment, the first and second insulating pattern layers INP1 and INP2 may protrude in the thickness direction of the base layer BSL (e.g., in the third direction DR3).

The first and second insulating pattern layers INP1 and INP2 may form a stepped portion so that the light emitting element LD may be readily aligned in the emission area. In an embodiment, each of the first and second insulating pattern layers INP1 and INP2 may be a partition wall (or wall). In an embodiment, each of the first and second insulating pattern layers INP1 and INP2 may include at least one organic material and/or inorganic material. However, embodiments are not limited to an example.

The alignment electrode layer ELT may include electrodes for aligning the light emitting elements LD. In an embodiment, the alignment electrode layer ELT may include a first electrode ELTA and a second electrode ELTG. In an embodiment, the first electrode ELTA may be a first alignment electrode, and the second electrode ELTG may be a second alignment electrode.

The alignment electrode layer ELT may be disposed on the pixel circuit layer PCL. A portion of the alignment electrode layer ELT may be disposed on the first and second insulating pattern layers INP1 and INP2. The first electrode ELTA may be supplied with a first alignment signal and/or first power. The second electrode ELTG may be supplied with a second alignment signal and/or second power.

The first electrode ELTA may be an electrode to which an AC signal is supplied to align the light emitting elements LD. The first electrode ELTA may be an electrode to which an anode signal is supplied such that the light emitting elements LD may emit light. The second electrode ELTG may be an electrode to which a ground signal is supplied to align the light emitting elements LD. The second electrode ELTG may be an electrode to which a cathode signal is supplied such that the light emitting elements LD may emit light.

The first electrode ELTA (or the first alignment electrode) and the second electrode ELTG (or the second alignment electrode) may be respectively supplied (or provided) with a first alignment signal and a second alignment signal at a processing step of aligning the light emitting elements LD. For example, ink including the light emitting elements LD may be supplied (or provided), the first alignment signal may be supplied to the first electrode ELTA, and the second alignment signal may be supplied to the second electrode ELTG. For example, the first alignment signal and the second alignment signal may have different waveforms, different potentials, and/or different phases. For example, the first alignment signal may be an AC signal, and the second alignment signal may be a ground signal. However, embodiments are not limited thereto. An electric field may be formed between (or over) the first electrode ELTA and the second electrode ELTG, so that the light emitting elements LD may be aligned between the first electrode ELTA and the second electrode ELTG based on the electric field. For example, the light emitting elements LD may be moved (or rotated) by force, e.g., dielectrophoresis (DEP) force, derived from the electric field and thus be aligned (or disposed) on the first alignment electrode and the second alignment electrode.

The first insulating layer INS1 may be disposed on the alignment electrode layer ELT. For example, the first insulating layer INS1 may cover the first electrode ELTA and the second electrode ELTG.

The bank BNK may be disposed on the first insulating layer INS1. The bank BNK may form a space in which ink including the light emitting element LD is received. For example, the ink including the light emitting element LD may be supplied into the space defined by the bank BNK.

In an embodiment, the bank BNK may include organic material such as acrylic resin, epoxy resin, phenol resin, polyamide resin, polyimide resin, polyester resin, polyphenylene sulfide resin, or benzocyclobutene (BCB). However, embodiments are not limited thereto.

The light emitting elements LD may be disposed on the first insulating layer INS1 in an area enclosed (or surrounded) by the bank BNK. In an embodiment, each of the light emitting elements LD may emit light based on electrical signals (e.g., an anode signal and a cathode signal) provided from the anode connection electrode CNEA and the cathode connection electrode CNEC.

The second insulating layer INS2 may be disposed on the light emitting elements LD. The second insulating layer INS2 may cover the active layer AL of each light emitting element LD. The second insulating layer INS2 may expose at least a portion of the light emitting element LD. For example, the second insulating layer INS2 may not cover the first end portion EP1 and the second end portion EP2 of the light emitting element LD. Hence, the first end portion EP1 and the second end portion EP2 of the light emitting element LD may be exposed and respectively connected (e.g., electrically connected) to the anode connection electrode CNEA and the cathode connection electrode CNEC. In an embodiment, another portion of the second insulating layer INS2 may be disposed on the bank BNK and the first insulating layer INS1.

In the case in which the second insulating layer INS2 is formed on the light emitting elements LD after the alignment of the light emitting elements LD has been completed, the light emitting elements LD may be prevented from being removed from the aligned positions.

The second insulating layer INS2 may have a single-layer structure or a multilayer structure. The second insulating layer INS2 may include one or more selected from the group consisting of silicon oxide (SiOx), silicon nitride (SiNx), silicon oxynitride (SiOxNy), aluminium nitride (AlNx), aluminium oxide (AlOx), zirconium oxide (ZrOx), hafnium oxide (HfOx), and titanium oxide (TiOx). However, embodiments are not limited thereto.

The anode connection electrode CNEA and the cathode connection electrode CNEC may be disposed on the first insulating layer INS1 and the second insulating layer INS2. The anode connection electrode CNEA may be connected (e.g., electrically connected) to the first end portion EP1 of the light emitting element LD. The cathode connection electrode CNEC may be connected (e.g., electrically connected) to the second end portion EP2 of the light emitting element LD.

The anode connection electrode CNEA may be connected (e.g., electrically connected) to the first electrode ELTA through a first contactor CNT1 passing through the first insulating layer INS1. The cathode connection electrode CNEC may be connected (e.g., electrically connected) to the second electrode ELTG through a second contactor CNT2 passing through the first insulating layer INS1. In an embodiment, the anode connection electrode CNEA may be connected (e.g., directly connected or electrically connected) to a line of the pixel circuit layer PCL through the first contactor CNT1. The cathode connection electrode CNEC may be connected (e.g., directly connected or electrically connected) to a line of the pixel circuit layer PCL through the second contactor CNT2.

In an embodiment, the anode connection electrode CNEA and the cathode connection electrode CNEC may be patterned at the same time point through the same process. However, embodiments are not limited thereto. After any one of the anode connection electrode CNEA and the cathode connection electrode CNEC is patterned, the other electrode may be patterned.

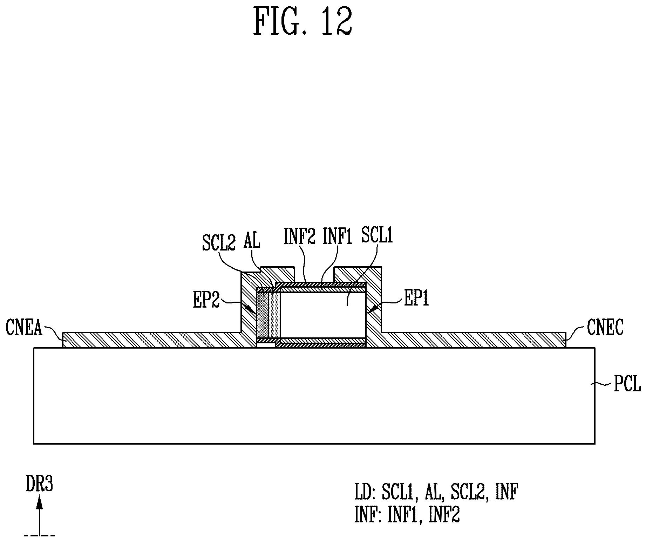

Referring to FIG. 12, a structure in which the connection electrodes CNEA and CNEC are connected (e.g., electrically connected) to the light emitting element LD will be described. FIG. 12 is a schematic cross-sectional view illustrating the connection electrodes CNEA and CNEC and the light emitting element LD in accordance with an embodiment.

In an embodiment, the insulating layer INF of the light emitting element LD may have a stepped portion. For example, the connection electrodes CNEA and CNEC disposed on the light emitting element LD may have shapes corresponding to the stepped portion. For example, a first stepped portion may be defined in an area between the active layer AL and the first semiconductor layer SCL1. Hence, a portion of the anode connection electrode CNEA may be bent in an area in which the stepped portion is formed. In an embodiment, a stepped portion may not be defined in an area in which the first insulating layer INF1 and the second insulating layer INF2 overlap each other. Hence, a portion of the cathode connection electrode CNEC may not be bent on the light emitting element LD.

An application field of the light emitting element LD in accordance with an embodiment is not limited. For example, the light emitting element LD may be a micro light emitting diode (a micro LED) which is transferred onto the base layer BSL in various transfer methods.

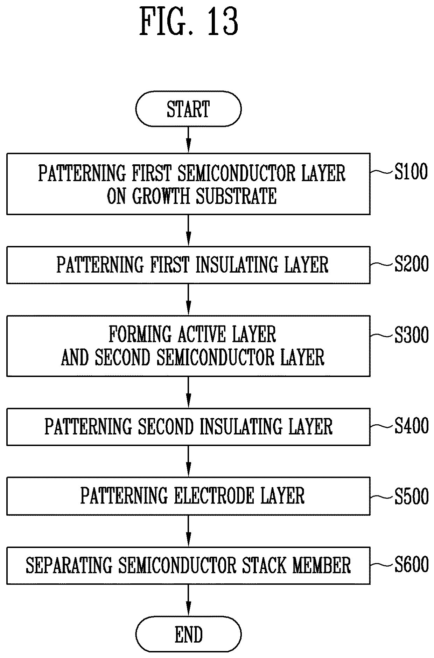

Hereinafter, a method of manufacturing a light emitting element LD in accordance with an embodiment will be described with reference to FIGS. 13 to 38. The redundant description, which is similar to or the same as that of the embodiments described above will be simplified, or may be omitted for descriptive convenience.

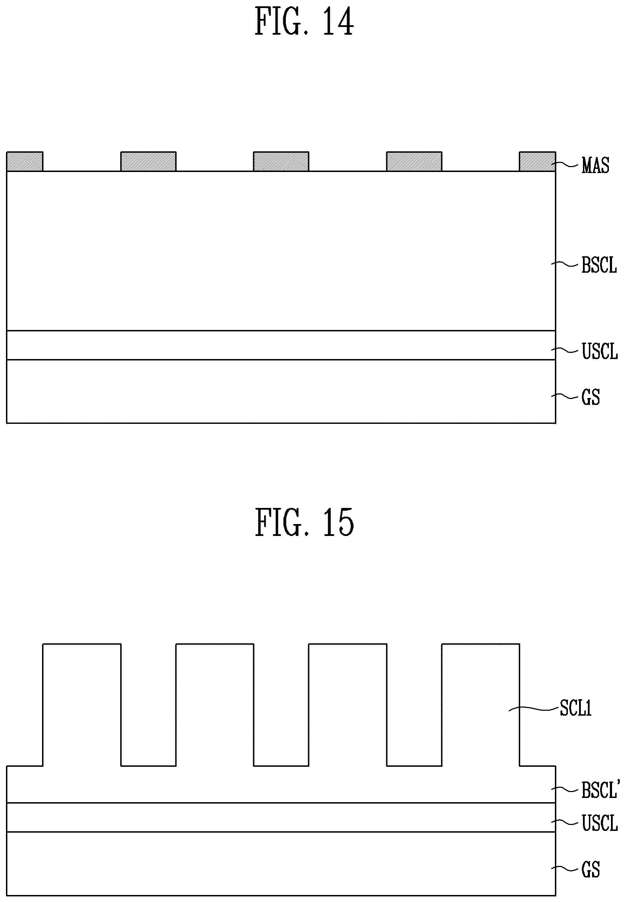

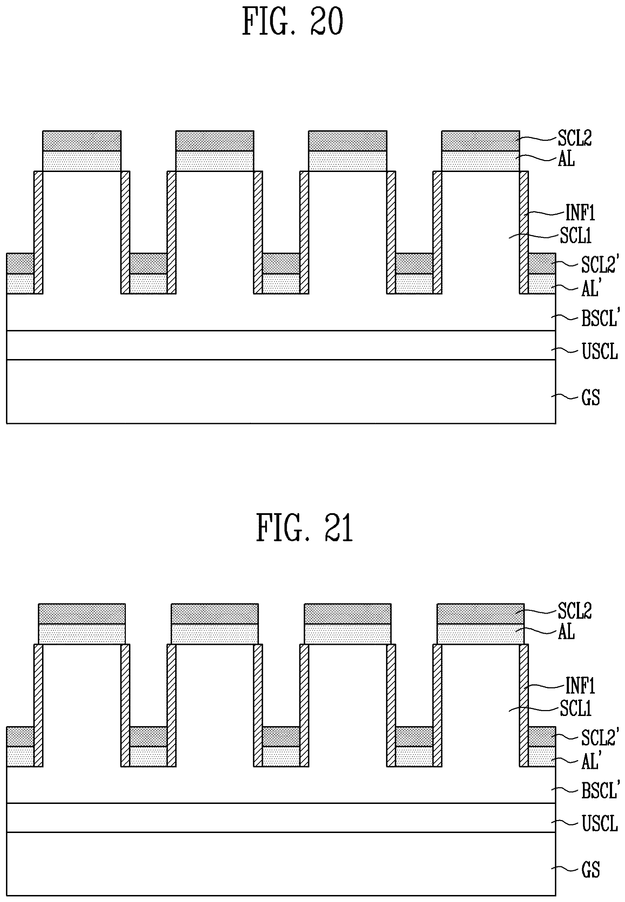

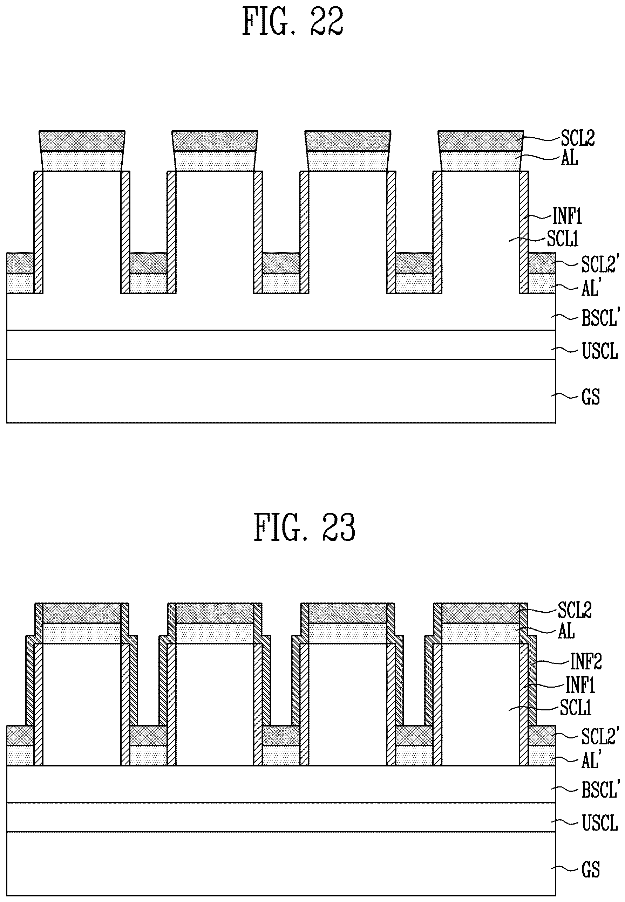

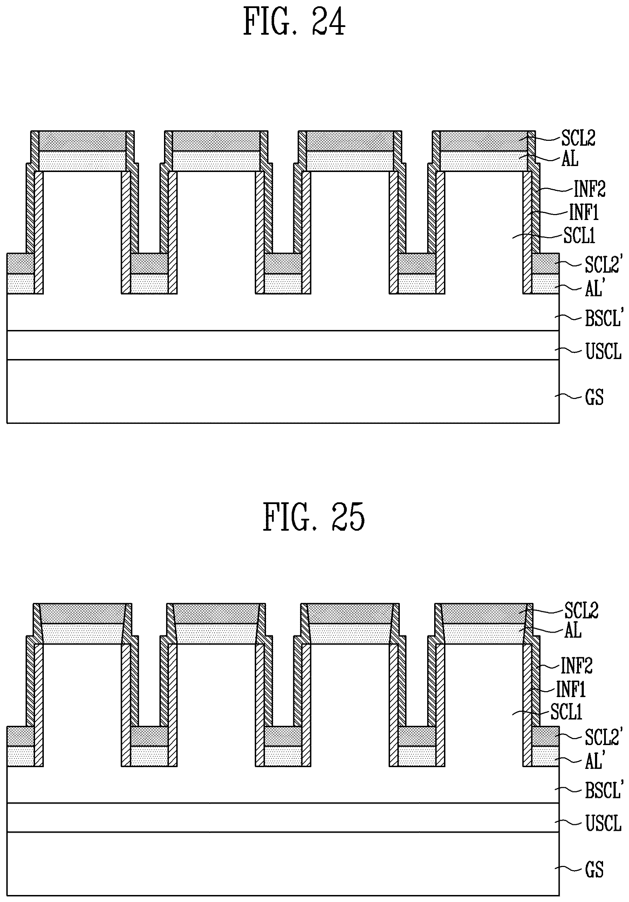

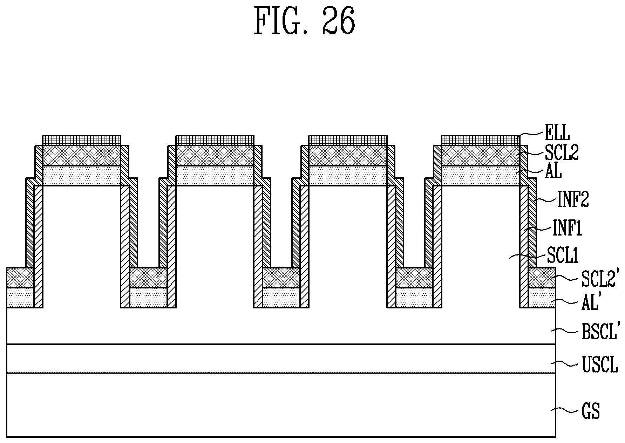

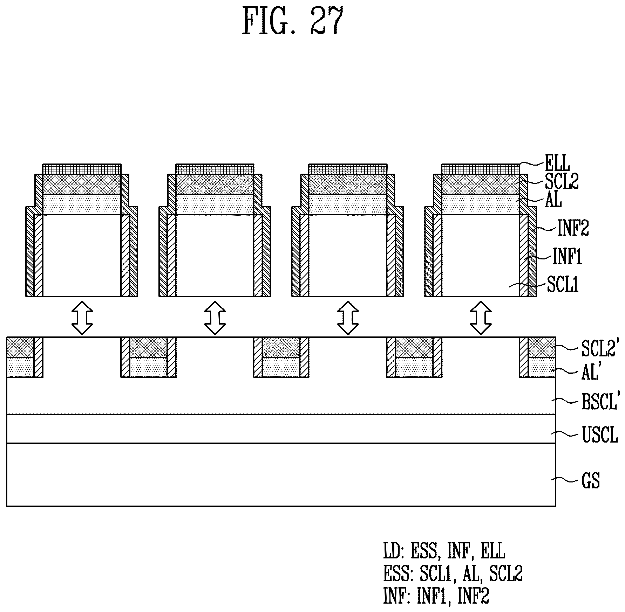

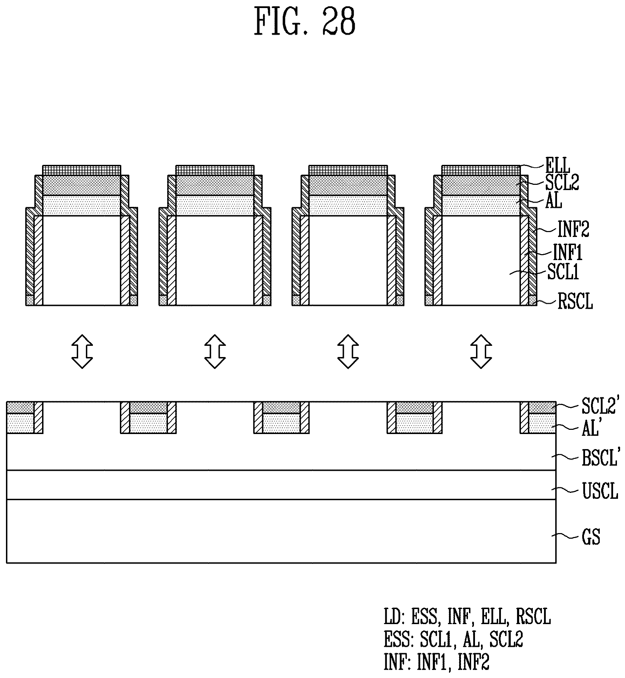

Methods of manufacturing the light emitting elements LD in accordance with the first to fourth embodiments will be described with reference to FIGS. 13 to 28. FIGS. 13 to 28 are schematic views illustrating the methods of manufacturing the light emitting elements in accordance with the first to fourth embodiments. FIGS. 14 to 19 illustrate the first to fourth embodiments. FIGS. 20 and 23 illustrate the first embodiment. FIGS. 21 and 24 illustrate the second embodiment. FIGS. 22 and 25 illustrate the third embodiment. FIG. 26 illustrates the step of forming the electrode layer ELL in accordance with the first to fourth embodiments, focused on the first embodiment. FIG. 27 illustrates the step of separating the light emitting elements LD in accordance with the first to third embodiments, focused on the first embodiment. FIG. 28 illustrates the step of separating the light emitting elements LD in accordance with the fourth embodiment.

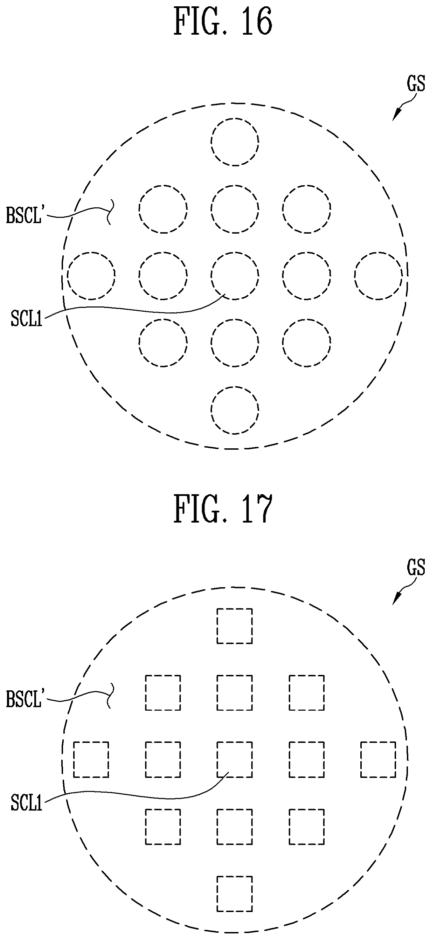

FIG. 13 is a schematic flowchart illustrating a method of manufacturing the light emitting element LD in accordance with one or more embodiments. FIGS. 14, 15, and 19 to 28 are schematic cross-sectional views illustrating a method of manufacturing the light emitting element LD in accordance with one or more embodiments. FIGS. 16 to 18 are schematic plan views each illustrating a method of manufacturing the light emitting element LD in accordance with an embodiment.

Referring to FIG. 13, a method of manufacturing the light emitting element LD in accordance with one or more embodiments may include a step S100 of patterning the first semiconductor layer on a growth substrate, a step S200 of patterning the first insulating layer, a step S300 of forming the active layer and the second semiconductor layer, a step S400 of patterning the second insulating layer, a step S500 of patterning the electrode layer, and a step S600 of separating the semiconductor stack member.

Referring to FIGS. 13 to 15, at the step S100 of patterning the first semiconductor layer on the growth substrate, an undoped semiconductor layer USCL and a base semiconductor layer BSCL may be formed (or disposed) on the growth substrate GS, and the first semiconductor layer SCL1 may be patterned by etching the base semiconductor layer BSCL.

The growth substrate GS may be a base board provided to grow a target material. For example, the growth substrate GS may be a wafer for epitaxial growth of the target material. The growth substrate GS may be a GaAs, GaP, or InP substrate, and material for forming the growth substrate GS is not limited to an example.

The undoped semiconductor layer USCL may be disposed on a buffer layer so as to minimize defects in the semiconductors formed on the growth substrate GS. In an embodiment, the undoped semiconductor layer USCL may include GaN which does not include a separate dopant, but the material for forming the undoped semiconductor layer USCL is not limited to an example.

The base semiconductor layer BSCL may be grown on the undoped semiconductor layer USCL in an epitaxial growth manner. The base semiconductor layer BSCL may be a layer for forming the first semiconductor layer SCL1, and may include one or more among the above-described N-type semiconductor materials. In an embodiment, the base semiconductor layer BSCL may be formed by a metal organic chemical vapor deposition (MOCVD) process, but embodiments are not limited thereto.

In the step S100, an etching mask MAS may be formed on the base semiconductor layer BSCL, and the base semiconductor layer BSCL may be etched using the etching mask MAS, whereby the first semiconductor layer SCL1 may be patterned. For example, the etching mask MAS may be manufactured by forming a plurality of layers, e.g., a silicon oxide (SiOx) layer and an aluminium layer, for forming the etching mask MAS, and thereafter patterning the plurality of layers. In an embodiment, a nano-imprint process or a photolithography process may be performed, and embodiments are not limited to one example.

In the step S100, an etched base semiconductor layer BSCL' and first semiconductor layers SCL1 which are individually spaced apart from each other may be manufactured by etching the base semiconductor layer BSCL.

In the step S100, a dry etching process may be performed to pattern the first semiconductor layers SCL1. Embodiments are not limited thereto. According to an embodiment, a wet etching process may be performed.

After the first semiconductor layers SCL1 are patterned, the mask MAS may be removed by various processes. The process of removing the mask MAS is not limited to a certain process. For example, the mask MAS may be etched and removed by using a solution including buffered oxide etchant (BOE).

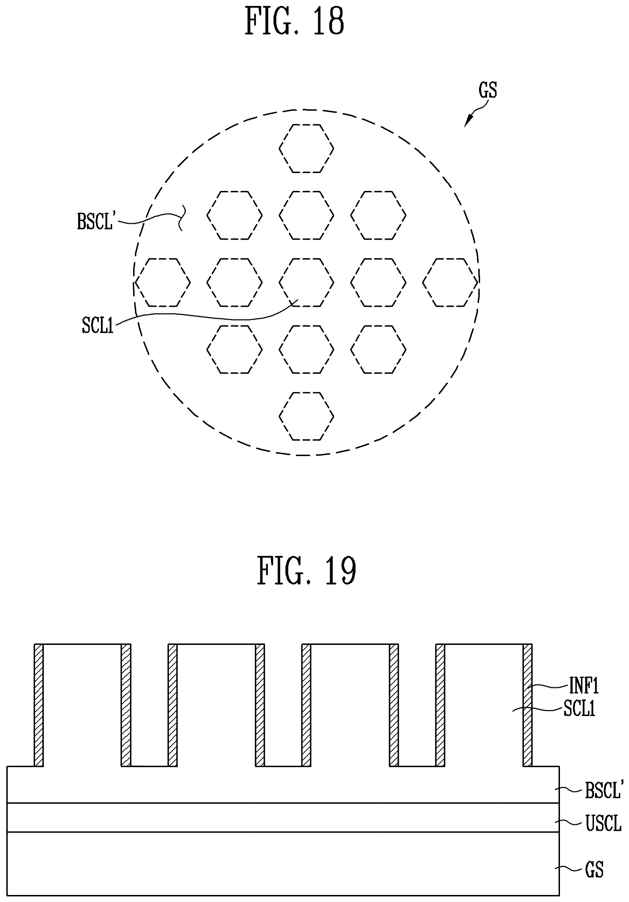

The cross-section of each patterned first semiconductor layer SCL1 may have various shapes. The cross-sectional shape of the patterned first semiconductor layer SCL1 may correspond to the cross-sectional shape of a bottom surface of the light emitting element LD to be manufactured. For example, the cross-section of the first semiconductor layer SCL1 may have a circular shape (refer to FIG. 16). In another example, the cross-section of the first semiconductor layer SCL1 may have a rectangular shape (refer to FIG. 17). In another example, the cross-section of the first semiconductor layer SCL1 may have a hexagonal shape (refer to FIG. 18). However, embodiments are not limited thereto.

In an embodiment, in the case where an upper surface (e.g., at least a portion of the upper surface) of the base semiconductor layer BSCL is exposed, an etching process for forming the first semiconductor layer SCL1 may be performed. For example, the etching process for the first semiconductor layer SCL1 may be performed before the active layer AL and the second semiconductor layer SCL2 are etched. For example, a structure for individually defining the light emitting element LD may be defined in case that the first semiconductor layer SCL1 is etched.

Referring to FIGS. 13 and 19, at the step S200 of patterning the first insulating layer, the first insulating layer INF1 may be patterned on a side surface of the first semiconductor layer SCL1.

In the step S200, to form the first insulating layer INF1, an insulating layer may be deposited and, thereafter, an upper surface of the first semiconductor layer SCL1 may be exposed by etching the deposited insulating layer. In an embodiment, the insulating layer for forming the first insulating layer INF1 may be formed by a chemical vapor deposition (CVD) method or an atomic layer deposition (ALD) method. However, embodiments are not limited thereto.

In the step S200, a dry etching process may be performed to pattern the first insulating layer INF1. Hence, the side surface of the first semiconductor layer SCL1 may be covered with the first insulating layer INF1, and the upper surface of the first semiconductor layer SCL1 may be exposed.

Referring to FIGS. 13, and 20 to 22, at the step S300 of forming the active layer and the second semiconductor layer, the active layer AL and the second semiconductor layer SCL2 may be formed (or disposed) on the upper surface of the first semiconductor layer SCL1. Hence, the semiconductor stack member ESS including the first semiconductor layer SCL1, the active layer AL, and the second semiconductor layer SCL2 may be manufactured.

In the step S300, the active layer AL and the second semiconductor layer SCL2 may be grown on the upper surface of the first semiconductor layer SCL1 exposed from the first insulating layer INF1. The active layer AL and the second semiconductor layer SCL2 may be formed by a metal organic chemical vapor deposition (MOCVD) process, but embodiments are not limited thereto.

In the step S300, according to an embodiment, in the case that the active layer AL and the second semiconductor layer SCL2 are formed, layers corresponding thereto may be formed on the exposed etched base semiconductor layer BSCL'. A lower active layer AL' and a lower second-semiconductor-layer SCL2' may be grown in an area between the first semiconductor layers SCL1 spaced apart from each other.

For example, the lower active layer AL' and the lower second-semiconductor-layer SCL2' may be interposed between the first insulating layers INF1 adjacent to each other. The lower active layer AL' and the lower second-semiconductor-layer SCL2' may be grown on the exposed etched base semiconductor layer BSCL'.

In an embodiment, quantum barrier layers BL and quantum well layers WL may be alternately grown to form the active layer AL. In an embodiment, as the quantum barrier layers BL and the quantum well layers WL are grown on the upper surface of the first semiconductor layer SCL1, an etching process for individually manufacturing the active layer AL may be omitted for descriptive convenience.

For example, the active layer AL and the second semiconductor layer SCL2 in accordance with an embodiment may be manufactured without performing an etching process. For example, during a process forming (e.g., growing) the active layer AL and the second semiconductor layer SCL2, the active layer AL and the second semiconductor layer SCL2 may be individually patterned. As described above, during the etching process for the active layer AL, there may be a structural risk such as occurrence of a defect in the active layer AL. For example, the emission efficiency may be reduced. However, in an embodiment, as the active layer AL is manufactured without performing an etching process, the light emitting element LD in accordance with the embodiment may have excellent emission efficiency.

In the step S300, to manufacture the light emitting elements LD in accordance with the first embodiment (e.g., the embodiment of FIGS. 1 to 3), the active layer AL and the second semiconductor layer SCL2 may be grown such that the cross-sectional areas (or cross-sectional sizes) thereof may be substantially the same as the cross-sectional area (or cross-sectional size) of the first semiconductor layer SCL1 (refer to FIG. 20), e.g., in the lateral direction (or width direction). In an embodiment, the active layer AL and the second semiconductor layer SCL2 may be grown to correspond to the surface area of the exposed upper surface of the first semiconductor layer SCL1.

In the step S300, to manufacture the light emitting elements LD in accordance with the second embodiment (e.g., the embodiment of FIGS. 4 and 5), the active layer AL and the second semiconductor layer SCL2 may be grown such that the cross-sectional areas thereof may be greater than the cross-sectional area of the first semiconductor layer SCL1 (refer to FIG. 21), e.g., in the lateral direction (or width direction). In the step S300, as the active layer AL has a cross-sectional area greater than the first semiconductor layer SCL1, the active layer AL may cover the entirety of the upper surface of the first semiconductor layer SCL1. In an embodiment, the grown active layer AL may cover a portion of the first semiconductor layer SCL1.

In the step S300, to manufacture the light emitting elements LD in accordance with the third embodiment (e.g., the embodiment of FIG. 6), the active layer AL and the second semiconductor layer SCL2 may be grown such that the cross-sectional areas thereof increase from the bottom to the top (refer to FIG. 22).

Referring to FIGS. 13, and 23 to 25, at the step S400 of patterning the second insulating layer, the second insulating layer INF2 may be patterned on the side surface of the semiconductor stack member ESS.

In the step S400, to form the second insulating layer INF2, an insulating layer may be deposited and, thereafter, an upper surface of the second semiconductor layer SCL2 may be exposed by etching the deposited insulating layer. In an embodiment, the insulating layer for forming the second insulating layer INF2 may be formed by the CVD method or the ALD method. However, embodiments are not limited thereto.

In the step S400, a portion of the second insulating layer INF2 may contact the first insulating layer INF1, and another portion of the second insulating layer INF2 may contact the active layer AL and the second semiconductor layer SCL2.

In the step S400, a dry etching process may be performed to pattern the second insulating layer INF2. Hence, the side surface of the first semiconductor layer SCL1 and the side surface of the first insulating layer INF1 may be covered with the second insulating layer INF2. The side surface of the active layer AL and the side surface of the second semiconductor layer SCL2 may be covered with the second insulating layer INF2. The upper surface of the second semiconductor layer SCL2 may be exposed.

FIG. 23 illustrates a structure in which the second insulating layer INF2 is formed to manufacture the light emitting element LD in accordance with the first embodiment. For example, the second insulating layer INF2 may be manufactured to cover the respective side surfaces of the active layer AL and the second semiconductor layer SCL2 that have substantially uniform cross-sectional areas.

FIG. 24 illustrates a structure in which the second insulating layer INF2 is formed to manufacture the light emitting element LD in accordance with the second embodiment. For example, the second insulating layer INF2 may be manufactured to cover the respective side surfaces of the active layer AL and the second semiconductor layer SCL2 that have cross-sectional areas greater than that of the first semiconductor layer SCL1.

FIG. 25 illustrates a structure in which the second insulating layer INF2 is formed to manufacture the light emitting element LD in accordance with the third embodiment. For example, the second insulating layer INF2 may be manufactured to cover the respective side surfaces of the active layer AL and the second semiconductor layer SCL2 each of which has a truncated shape.

Referring to FIGS. 13 and 26, at the step S500 of patterning the electrode layer, the electrode layer ELL may be patterned on the exposed upper surface of the second semiconductor layer SCL2.

In the step S500, to form the electrode layer ELL, a base electrode layer may be deposited and, thereafter, the electrode layer ELL may be patterned by etching the deposited base electrode layer. In an embodiment, the base electrode layer may be formed by a sputtering method. However, embodiments are not limited thereto.

In the step S500, the electrode layer ELL may be connected (e.g., electrically connected) to the second semiconductor layer SCL2, and the insulating layer INF may be exposed.

Referring to FIGS. 13, 27, and 28, at the step S600 of separating the semiconductor stack member, light emitting elements LD which are individually provided may be manufactured by separating semiconductor stack members ESS that are spaced apart from each other. For example, each of the light emitting elements LD may be manufactured to include the semiconductor stack member ESS, the insulating layer INF, and the electrode layer ELL. In an embodiment, the light emitting elements LD may be manufactured to further include an auxiliary semiconductor layer RSCL.

In the step S600, the light emitting elements LD may be individually separated by cutting respective portions of the first semiconductor layers SCL1. For example, a line along which the semiconductor stack member ESS is individually separated may be defined in the first semiconductor layer SCL1.

In the step S600, according to an embodiment, the light emitting elements LD may be individually separated by external physical force applied thereto. For example, respective lower portions of the light emitting elements LD may be separated by applying an ultrasonic wave to the light emitting elements LD, whereby the light emitting elements LD may be individually provided. As another example, a laser-lift-off process, a thermal process, or the like may be performed to separate the light emitting elements LD. However, embodiments are not limited thereto, and various processes may be applied.

In an embodiment, a line along which the light emitting elements LD are separated may be defined at a position corresponding to the height of the lower second-semiconductor-layer SCL2'. For example, a separation line defined in the first semiconductor layer SCL1 may be determined (or defined) to be at a position identical to or higher than an uppermost surface of the lower second-semiconductor layer SCL2'. Hence, an outer surface of the second insulating layer INF2 may be exposed, and the structure of the insulating layer INF capable of electrically separating the light emitting elements LD from each other may be formed, whereby the light emitting element LD in accordance with an embodiment may be provided.

Referring to FIG. 28, in an embodiment, the line along which the light emitting elements LD are separated may overlap a portion of the lower second-semiconductor layer SCL2'. For example, the light emitting elements LD in accordance with the fourth embodiment may be manufactured.

In an embodiment, the position of the line along which the light emitting elements LD are separated may be defined to overlap a portion of the lower second-semiconductor-layer SCL2'. A layer including the same material as the second semiconductor layer SCL2 may be provided on a portion (e.g., the second insulating layer INF2) of the insulating layer INF of the manufactured light emitting element LD.

For example, at least a portion of the lower second-semiconductor-layer SCL2' may remain on at least a portion of a lower portion of the first insulating layer INF1 of the light emitting element LD, thereby forming an auxiliary semiconductor layer RSCL, which covers the first insulating layer INF1 in the same manner as that of the second insulating layer INF2, and comprises a P-type semiconductor material.

The method of manufacturing the light emitting element LD in accordance with the fifth embodiment will be described with reference to FIGS. 28 to 32. The redundant description, which is similar to or the same as that of the embodiments described above will be simplified, or may be omitted for descriptive convenience.

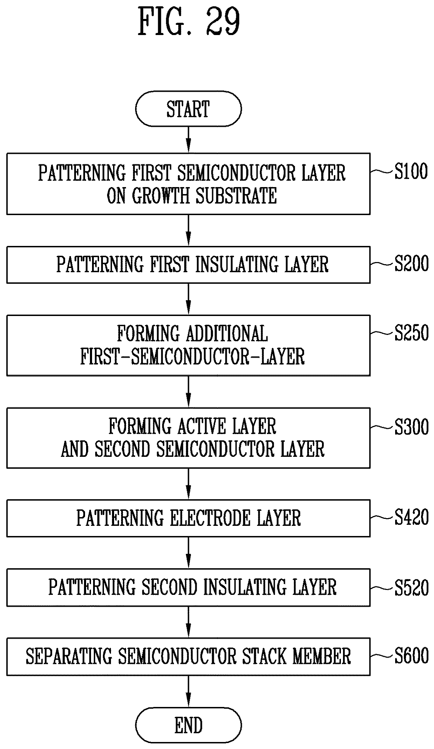

FIGS. 29 to 32 are schematic views illustrating the method of manufacturing the light emitting element LD in accordance with the fifth embodiment.

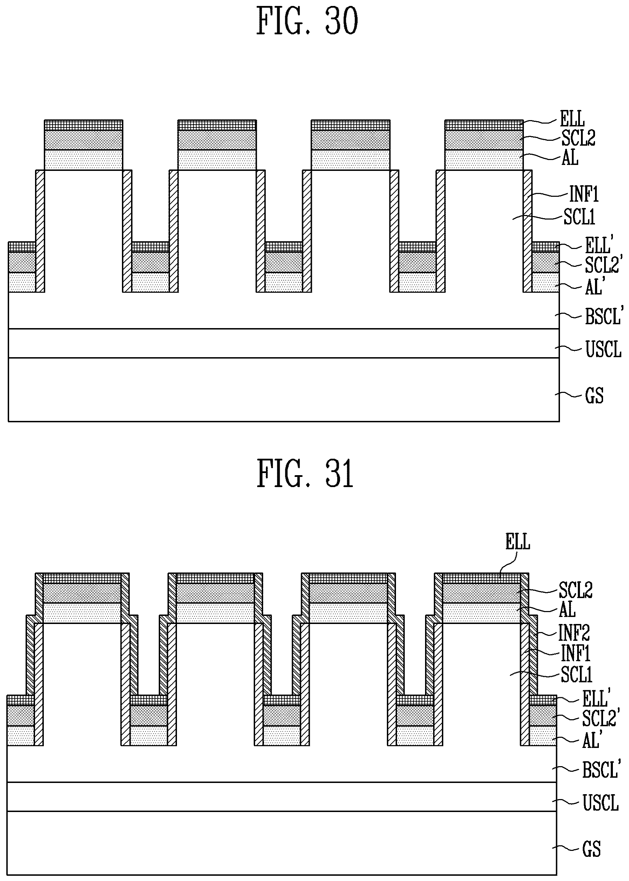

FIG. 29 is a schematic flowchart illustrating a method of manufacturing the light emitting element LD in accordance with the fifth embodiment. FIGS. 30 to 32 are schematic cross-sectional views illustrating the method of manufacturing the light emitting element LD in accordance with the fifth embodiment.

In an embodiment, the method of manufacturing the light emitting element LD in accordance with the fifth embodiment is different from the method of manufacturing the light emitting element LD in accordance with the one or more embodiments described above, in that the electrode layer ELL is manufactured before the second insulating layer INF2 is formed.

For example, referring to FIG. 29, a method of manufacturing the light emitting element LD in accordance with an embodiment may include a step S100 of patterning the first semiconductor layer on the growth substrate, a step S200 of patterning the first insulating layer, a step S300 of forming the active layer and the second semiconductor layer, a step S420 of patterning the electrode layer, a step S520 of patterning the second insulating layer, and a step S600 of separating the semiconductor stack member.

Referring to FIG. 30, at the step S300 of forming the active layer and the second semiconductor layer and at the step S420 of patterning the electrode layer, the active layer AL, the lower active layer AL', the second semiconductor layer SCL2, and the lower second-semiconductor-layer SCL2' may be grown on the patterned first semiconductor layer SCL1 and, thereafter, the electrode layer ELL and the lower electrode layer ELL' may be patterned.

The electrode layer ELL and the lower electrode layer ELL' may be formed by the same process. For example, after a base electrode for forming the electrode layer ELL and the lower electrode layer ELL' is deposited, the electrode layer ELL and the lower electrode layer ELL' may be manufactured by etching the deposited base electrode.

In an embodiment, the lower electrode layer ELL' may be disposed on the lower second-semiconductor-layer SCL2', and the electrode layer ELL may be disposed on the second semiconductor layer SCL2.

Referring to FIG. 31, at the step S520 of patterning the second insulating layer, the second insulating layer INF2 may be patterned on the side surface of the semiconductor stack member ESS.

In the step S520, the second insulating layer INF2 may expose the electrode layer ELL. In an embodiment, a portion of the second insulating layer INF2 may cover the side surface of the electrode layer ELL. In an embodiment, a portion of the second insulating layer INF2 may contact a portion of the lower electrode layer ELL'.

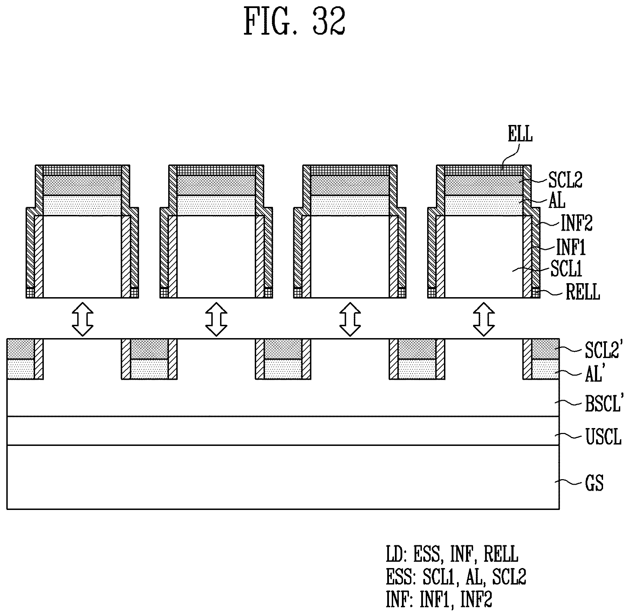

Referring to FIG. 32, at the step S600 of separating the semiconductor stack member, light emitting elements LD which are individually provided may be manufactured by separating semiconductor stack members ESS that are spaced apart from each other.

In the step S600, a line along which the light emitting elements LD are separated may overlap a portion of the lower electrode layer ELL'. For example, the light emitting elements LD in accordance with the fifth embodiment may be manufactured.

In an embodiment, the position of the line along which the light emitting elements LD are separated may be defined to overlap a portion of the lower second-semiconductor-layer SCL2'. The same material as the electrode layer ELL may be provided on a portion (e.g., the second insulating layer INF2) of the insulating layer INF of the manufactured light emitting element LD.

For example, at least a portion of the lower electrode layer ELL' may remain on at least a portion of a lower portion of the first insulating layer INF1 of the light emitting element LD, thereby forming an auxiliary electrode layer RELL which covers the first insulating layer INF1 in the same manner as that of the second insulating layer INF2, and includes a conductive material.

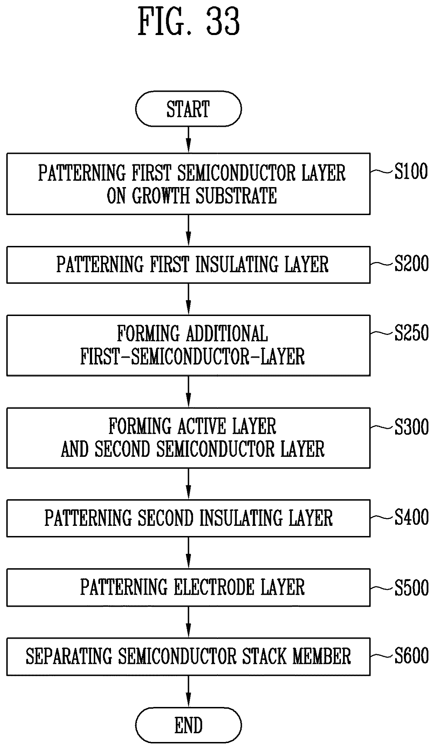

The method of manufacturing the light emitting element LD in accordance with the sixth embodiment will be described with reference to FIGS. 33 to 38. The redundant description, which is similar to or the same as that of the embodiments described above will be simplified, or may be omitted for descriptive convenience.

FIGS. 33 to 38 are schematic views illustrating the method of manufacturing the light emitting element LD in accordance with the sixth embodiment.

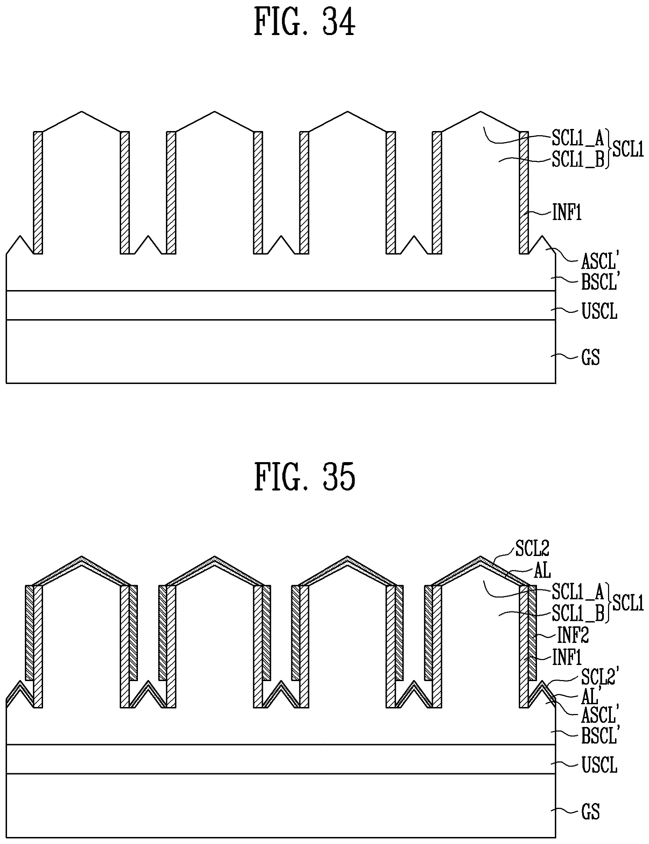

FIG. 33 is a schematic flowchart illustrating the method of manufacturing the light emitting element LD in accordance with the sixth embodiment. FIGS. 34 to 38 are schematic cross-sectional views illustrating the method of manufacturing the light emitting element LD in accordance with the sixth embodiment.

In an embodiment, the method of manufacturing the light emitting element LD in accordance with the sixth embodiment is different from the method of manufacturing the light emitting element LD in accordance with the one or more embodiments described above, in that a step S250 of forming an additional first-semiconductor-layer is further performed.

For example, referring to FIG. 33, a method of manufacturing the light emitting element LD in accordance with an embodiment may include a step S100 of patterning the first semiconductor layer on the growth substrate, a step S200 of patterning the first insulating layer, a step S250 of forming the additional first-semiconductor-layer, a step S300 of forming the active layer and the second semiconductor layer, a step S400 of patterning the second insulating layer, a step S500 of patterning the electrode layer, and a step S600 of separating the semiconductor stack member.

For example, in the method of manufacturing the light emitting element LD in accordance with an embodiment, the step S250 of forming the additional first-semiconductor-layer may be performed after the step S100 of patterning the first semiconductor layer and the step S200 of patterning the first insulating layer are performed.

The additional first-semiconductor-layer SCL1_A may correspond to the protrusion SCL1_A described above.

Referring to FIGS. 33 and 34, the additional first-semiconductor-layer SCL1_A may be grown on the upper surface of the first semiconductor layer SCL1 that is exposed from the first insulating layer INF1.

In the step S250, as the additional first-semiconductor-layer SCL1_A has a shape in which at least a portion thereof protrudes, an exposed surface of the additional first-semiconductor-layer SCL1_A may have a surface area (or surface size) greater than a surface area (or surface size) of the upper surface of the previously-patterned first semiconductor layer SCL1.

In the step S250, a lower additional first-semiconductor-layer ASCL' may be grown on the etched base semiconductor layer BSCL'.

Referring to FIGS. 33 and 35, after the additional first-semiconductor-layer SCL1_A is grown, the active layer AL and the second semiconductor layer SCL2 may be grown.

In the step S300, the active layer AL and the second semiconductor layer SCL2 may be grown on the exposed additional first-semiconductor-layer SCL1_A. Hence, the surface area between the active layer AL and the additional first-semiconductor-layer SCL1_A and the surface area between the active layer AL and the second semiconductor layer SCL2 each may be greater than the surface area of the upper surface of the first semiconductor layer SCL1.

In the step S300, a lower active layer AL' and a lower second-semiconductor-layer SCL2' may be grown on the lower additional first-semiconductor-layer ASCL'.

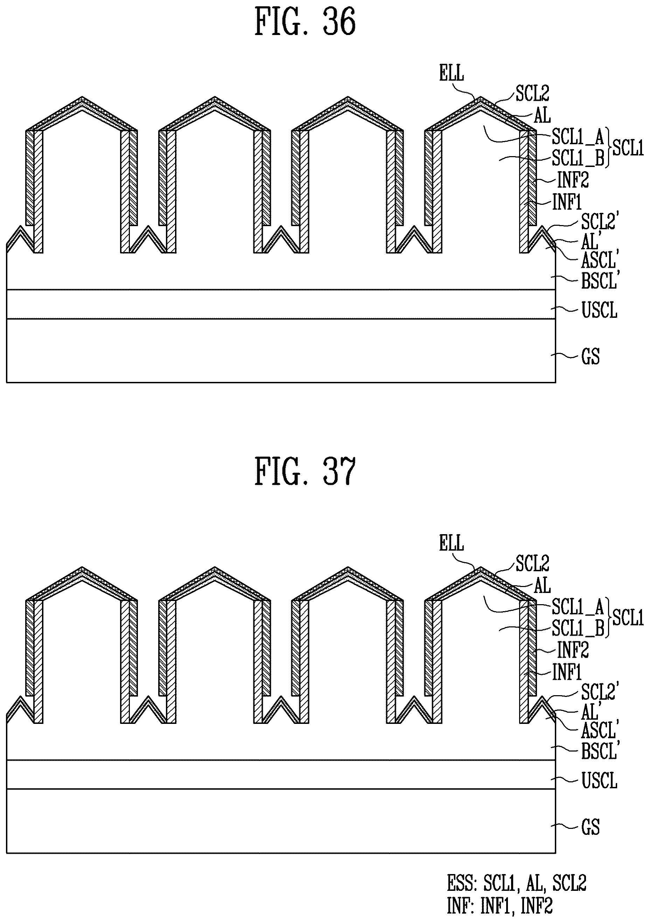

Referring to FIGS. 33 and 36, at the step S400 of patterning the second insulating layer, the second insulating layer INF2 may be patterned to cover a side surface of the first insulating layer INF1. In the step S400, the second insulating layer INF2 may cover the side surface of the semiconductor stack member ESS, and may expose the outer surface of the second semiconductor layer SCL2. For example, a portion of the second insulating layer INF2 may cover a surface of the second semiconductor layer SCL2.

Referring to FIGS. 33 and 37, at the step S500 of patterning the electrode layer, the electrode layer ELL may be patterned on the exposed second semiconductor layer SCL2. In the step S500, the electrode layer ELL may have a shape corresponding to that of the additional first-semiconductor-layer SCL1_A.

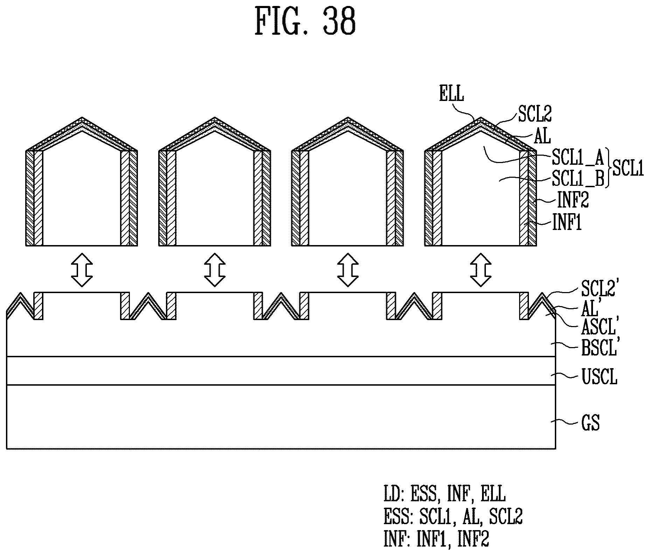

Referring to FIG. 33 and 38, at the step S600 of separating the semiconductor stack member, a portion of each of the first semiconductor layer SCL1 and the insulating layer INF may be cut, so that individually separated light emitting elements LD may be provided. For example, the light emitting elements LD may be separated along the separation line. As a result, the light emitting elements LD in accordance with the sixth embodiment may be manufactured.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A method of manufacturing a light emitting element, the method comprising:
patterning a first semiconductor layer on a substrate;
patterning a first insulating layer on a side surface of the first semiconductor layer; and
forming an active layer and a second semiconductor layer on the first semiconductor layer.

2. The method of claim 1, wherein the patterning of the first semiconductor layer comprises:
forming a base semiconductor layer on the substrate; and
etching at least a portion of the base semiconductor layer by using a mask exposing an upper surface of the base semiconductor layer.

3. The method of claim 2, wherein the patterning of the first semiconductor layer and the forming of the second semiconductor layer are performed in separate processes.

4. The method of claim 2, wherein
the forming of the active layer and the second semiconductor layer comprises depositing the active layer and the second semiconductor layer, and
the depositing of the active layer and the second semiconductor layer comprises individually patterning the active layer and the second semiconductor layer.

5. The method of claim 1, wherein the patterning of the first insulating layer comprises exposing an upper surface of the first semiconductor layer from the first insulating layer.

6. The method of claim 5, wherein the forming of the active layer and the second semiconductor layer comprises growing the active layer and the second semiconductor layer on the exposed upper surface of the first semiconductor layer.

7. The method of claim 6, wherein the first insulating layer covers the side surface of the first semiconductor layer such that the active layer and the second semiconductor layer are not grown on the side surface of the first semiconductor layer.

8. The method of claim 1, further comprising:
patterning the second insulating layer,
wherein the patterning of the second insulating layer comprises:
disposing a first portion of the second insulating layer on the first insulating layer; and
disposing a second portion of the second insulating layer on a side surface of the active layer and a side surface of the second semiconductor layer.

9. The method of claim 8, further comprising:
patterning an electrode layer on the second semiconductor layer after the patterning of the second insulating layer.

10. The method of claim 1, wherein
the first semiconductor layer, the active layer, and the second semiconductor layer form a semiconductor stack member,
the first semiconductor layer comprises first semiconductor layers adjacent to each other,
the method further comprising:
forming a lower active layer and a lower second-semiconductor-layer between the first semiconductor layers adjacent to each other at a same time to forming the active layer and the second semiconductor layer; and
separating the semiconductor stack member from the substrate,
the separating of the semiconductor stack member comprises individually separating the semiconductor stack member along a separation line that is a portion of the first semiconductor layer, and
the separation line is defined at a position substantially identical to or higher than an uppermost surface of the lower second-semiconductor-layer.

11. The method of claim 1, further comprising:
forming an additional first-semiconductor-layer on the first semiconductor layer.

12. The method of claim 11, further comprising:
forming the active layer and the second semiconductor layer on the additional first-semiconductor-layer, and
wherein a surface area of an upper surface of the first semiconductor layer, on which the additional first-semiconductor-layer grows, is smaller than a surface area of a proximity surface between the additional first-semiconductor-layer and the active layer.

13. A light emitting element comprising:
a semiconductor stack member comprising:
a first semiconductor layer,
a second semiconductor layer, and
an active layer disposed between the first semiconductor layer and the second semiconductor layer; and
an insulating layer disposed on a side surface of the semiconductor stack member, wherein
the insulating layer comprises:
a first insulating layer disposed on a side surface of the first semiconductor layer and exposing a side surface of the active layer or a side surface of the second semiconductor layer, and
a second insulating layer disposed on the side surface of the semiconductor stack member, and
the second insulating layer comprises:
a first portion not contacting the first semiconductor layer by the first insulating layer interposed between the first portion and the first semiconductor layer, and
a second portion contacting the active layer and the second semiconductor layer.

14. The light emitting element of claim 13, wherein
the active layer comprises:
a quantum well layer comprising a first side surface, and
a quantum barrier layer comprising a second side surface, and
the first side surface and the second side surface form an even plane.

15. The light emitting element of claim 14, wherein the first side surface and the second side surface form a side surface that does not have any recess.

16. The light emitting element of claim 13, wherein the second insulating layer forms a stepped portion in an area between the first portion and the second portion of the second insulating layer.

17. The light emitting element of claim 16, wherein the insulating layer has a first thickness in an area overlapping the first semiconductor layer, and has a second thickness less than the first thickness in an area overlapping the active layer.

18. The light emitting element of claim 16, wherein the first insulating layer does not cover the side surface of the active layer and the side surface of the second semiconductor layer.

19. The light emitting element of claim 13, wherein the active layer and
the first semiconductor layer have a same cross-sectional size.

20. The light emitting element of claim 13, wherein
the active layer comprises an active surface facing the first semiconductor layer, and
the active surface entirely covers the first semiconductor layer, and comprises a portion of the active surface that does not contact the first semiconductor layer.

21. The light emitting element of claim 13, wherein the active layer has a truncated shape.

22. The light emitting element of claim 13, wherein the first semiconductor layer comprises:
a body overlapping the first insulating layer and the second insulating layer, and
a protrusion protruding from the body.

23. The light emitting element of claim 13, further comprising:
a first end portion adjacent to the first semiconductor layer,
a second end portion adjacent to the second semiconductor layer, and
an auxiliary semiconductor layer disposed on the first insulating layer in an area adjacent to the first end portion and comprising a material substantially identical to a material of the second semiconductor layer.

24. The light emitting element of claim 13, further comprising:
a first end portion adjacent to the first semiconductor layer,
a second end portion adjacent to the second semiconductor layer,
an electrode layer disposed on the second semiconductor layer, and
an auxiliary electrode layer disposed on the first insulating layer in an area adjacent to the first end portion and comprising a material substantially identical to a material of the electrode layer.

25. A display device comprising
a base layer; and
a light-emitting-element layer disposed on the base layer, and comprising the light emitting element of claim 13, wherein
the light emitting element comprises:
a first electrode and a second electrode spaced apart from each other; and
an anode connection electrode electrically connected to a first end portion of the light emitting element, and
a cathode connection electrode electrically connected to a second end portion of the light emitting element, and
the light emitting element is aligned between the first electrode and the second electrode.
